# EUROPEAN PATENT APPLICATION

(11) **EP 4 510 180 A1**
(43) Date of publication of application: **19.02.2025**
(21) Application number: 23788218.8
(22) Date of filing: 04.04.2023
(51) Int. Cl.: H01L 23/02, H01L 27/146

(54) **SEMICONDUCTOR DEVICE AND ELECTRONIC EQUIPMENT**

(30) Priority: 12.04.2022 JP 2022065881
(71) Applicant: Sony Semiconductor Solutions Corporation, Atsugi-shi, Kanagawa 243-0014 (JP)
(72) Inventor: TSUCHIYA, Koji, Atsugi-shi, Kanagawa 243-0014 (JP); NAKAYAMA, Hirokazu, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/013965
(87) International publication number: WO 2023/199799

(57) **Abstract**

The present disclosure relates to a semiconductor device that makes a cover member easy to remove without leaving, with the cover member removed from a package main body portion, an adhesive for fixing the cover member on a support surface of the package main body portion that supports the cover member.

The semiconductor device includes a semiconductor element, a package main body portion including a substrate portion on which the semiconductor element is installed and a frame portion that is provided on the substrate portion so as to surround the semiconductor element and has an opening portion formed on an upper side, and a cover member that closes the opening portion with the cover member supported by a support surface forming an opening end surface of the opening portion of the package main body portion. The cover member includes an overhanging portion that sticks out over an outline of the support surface in plan view and is provided with the overhanging portion fixed to the frame portion.

## Description

### TECHNICAL FIELD

The present disclosure relates to a semiconductor device and an electronic device.

### BACKGROUND ART

Examples of a known semiconductor device including a semiconductor element (semiconductor chip) such as an imaging element, such as a CMOS image sensor, or a light emitting element, such as a semiconductor laser, include a semiconductor device having a hollow package structure obtained by tightly covering an upper opening portion of a box-shaped package main body portion having a semiconductor chip installed therein with a cover glass that is a transparent cover member. The cover glass is, for example, a member required to make the semiconductor device easy to handle during a process of mounting a lens unit on the semiconductor device and the like, or to prevent foreign matter from entering the package of the semiconductor device.

Regarding the package structure as described above, for example, when the semiconductor device is incorporated into a predetermined set structure forming an electronic device such as a camera device, the cover glass is removed from the package main body portion for the reason that, for example, the cover glass may cause ghost, flare, or an error in optical path distance. That is, as one mode of use of the semiconductor device, the semiconductor device is used with the cover glass once attached to the package main body portion removed.

Generally speaking, the cover glass, however, is fixed to the opening portion of the package main body portion with an adhesive to tightly cover the opening portion, so that it is not easy to remove the cover glass. With the current state of the art, the cover glass is often removed by forcibly taking off a bonding portion of the cover glass bonded to the package main body portion.

Therefore, Patent Document 1 discloses a configuration where a cover glass is detachably fixed to a housing forming a package main body portion with an adhesive as a detachably attachable means in order to prevent a ghost caused by light reflecting off the cover glass. Patent Document 1 discloses that the adhesive has such an adhesive strength as to prevent the cover glass from separating during handling such as transportation of an imaging device or processing and to allow the cover glass to separate without breaking the housing or the cover glass.

### CITATION LIST

### PATENT DOCUMENT

Patent Document 1: Japanese Patent Application Laid-Open No. 11-355508

### SUMMARY OF THE INVENTION

### PROBLEMS TO BE SOLVED BY THE INVENTION

Patent Document 1 includes a description of the adhesive strength of the adhesive for fixing the cover glass, but does not specifically disclose a material of the adhesive, a bonding method, and the like. It is therefore difficult to achieve the configuration disclosed in Patent Document 1 from a technical perspective.

Furthermore, in a case where the adhesive is used to fix the cover glass, the adhesive remains as a residue on a glass fixing surface of the package main body portion to which the cover glass is fixed with the cover glass removed. It is therefore difficult to use the glass fixing surface as a joint surface to be joined to a casing or the like of the set structure into which the semiconductor device is incorporated or a joint surface of a new component to be joined to the package main body portion. Furthermore, when the adhesive left on the glass fixing surface adheres as dust to the semiconductor chip inside the package, the adhesive may cause a decrease in performance of the semiconductor chip.

Furthermore, there is also a technique of temporarily fixing the cover glass to the package main body portion with an adhesive tape. The adhesive tape, however, cannot withstand heat generated during reflow soldering by which the semiconductor device is installed on the set board, so that it is necessary to remove the cover glass before the reflow soldering. Therefore, there is a possibility that, during the reflow soldering, the exposed semiconductor chip is contaminated. Furthermore, the method using the adhesive tape is not preferable in terms of productivity because the temporary fixing of the cover glass with the adhesive tape is manually performed.

It is therefore an object of the present technology to provide a semiconductor device and an electronic device that make a cover member easy to remove without leaving, with the cover member removed from a package main body portion, an adhesive for fixing the cover member on a support surface of the package main body portion that supports the cover member.

### SOLUTIONS TO PROBLEMS

A semiconductor device according to the present technology including a semiconductor element, a package main body portion including a substrate portion on which the semiconductor element is installed and a frame portion that is provided on the substrate portion so as to surround the semiconductor element and has an opening portion formed on an upper side, and a cover member that closes the opening portion with the cover member supported by a support surface forming an opening end surface of the opening portion of the package main body portion, in which the cover member includes an overhanging portion that sticks out over an outline of the support surface in plan view and is provided with the overhanging portion fixed to the frame portion.

Another aspect of the semiconductor device according to the present technology is the semiconductor device in which the frame portion includes a wall portion provided on four sides, the wall portion forming the support surface in a rectangular frame shape in plan view, and the overhanging portion is a portion extending along at least one side of the outline of the support surface in plan view, and the package main body portion includes a cover fixing portion that is provided on an outer side of the wall portion and to which the overhanging portion is fixed.

Another aspect of the semiconductor device according to the present technology is the semiconductor device in which the cover fixing portion includes a plate-shaped portion that is provided at an upper end portion of the wall portion and has an upper plate surface as a fixed surface to which the overhanging portion is fixed.

Another aspect of the semiconductor device according to the present technology is the semiconductor device in which the cover fixing portion includes a fragile portion provided adjacent to the wall portion, the fragile portion having reduced stiffness in a direction in which the fragile portion breaks downward.

Another aspect of the semiconductor device according to the present technology is the semiconductor device in which the cover fixing portion includes a main body portion provided at a position spaced apart from the wall portion, the main body portion having an upper surface as a fixed surface to which the overhanging portion is fixed, and a connecting portion that connects the main body portion and the wall portion and is lower in stiffness than the main body portion.

Another aspect of the semiconductor device according to the present technology is the semiconductor device in which the connecting portion includes a plurality of rib portions provided at predetermined intervals in a direction of a side of the support surface, and the fixed surface has a joint portion provided in an area where none of the rib portions is formed in the direction of the side, the joint portion including an adhesive with which the overhanging portion is fixed.

Another aspect of the semiconductor device according to the present technology is the semiconductor device in which the overhanging portion is fixed to the fixed surface by a joint portion including an adhesive, and the cover fixing portion is provided so as to make the fixed surface lower in position than the support surface by a thickness of the joint portion.

Another aspect of the semiconductor device according to the present technology is the semiconductor device in which the frame portion includes a wall portion provided on four sides, the wall portion forming the support surface in a rectangular frame shape in plan view, and the overhanging portion includes a fixing surface forming portion, the fixing surface forming portion extending along at least one side of the outline of the support surface in plan view, and having a fixing surface formed facing an outer side surface of the wall portion.

Another aspect of the semiconductor device according to the present technology is the semiconductor device in which the fixing surface forming portion has a lower end surface, the lower end surface being lower in position than a supported surface of the cover member supported by the support surface and forming a corner portion with the fixed surface, the corner portion having a chamfered shape.

Another aspect of the semiconductor device according to the present technology is the semiconductor device in which the frame portion includes a wall portion provided on four sides, the wall portion forming the support surface in a rectangular frame shape in plan view, and the wall portion has, on outer side of the support surface, a fixed surface to which the overhanging portion is fixed, the fixed surface forming a step lower than the support surface.

Another aspect of the semiconductor device according to the present technology is the semiconductor device in which the wall portion forms a groove portion having the fixed surface as a bottom surface.

Another aspect of the semiconductor device according to the present technology is the semiconductor device in which the cover member has an opposite-side overhanging portion provided on an opposite side from the overhanging portion, the opposite-side overhanging portion sticking out over the outline of the support surface in plan view.

An electronic device according to the present technology including a semiconductor device, the semiconductor device including a semiconductor element, a package main body portion including a substrate portion on which the semiconductor element is installed and a frame portion that is provided on the substrate portion so as to surround the semiconductor element and has an opening portion formed on an upper side, and a cover member that closes the opening portion with the cover member supported by a support surface forming an opening end surface of the opening portion of the package main body portion, in which the cover member includes an overhanging portion that sticks out over an outline of the support surface in plan view and is provided with the overhanging portion fixed to the frame portion.

An electronic device according to the present technology including a semiconductor device, the semiconductor device including a semiconductor element, and a package main body portion including a substrate portion on which the semiconductor element is installed and a frame portion that is provided on the substrate portion so as to surround the semiconductor element and has an opening portion formed on an upper side, in which the package main body portion has a fixation mark of a cover member that closes the opening portion of the package main body portion with the cover member supported by a support surface forming an opening end surface of the opening portion.

### BRIEF DESCRIPTION OF DRAWINGS

Fig. 1 is a side cross-sectional view of a configuration of a solid-state imaging device according to a first embodiment of the present technology.
Fig. 2 is a plan view of the configuration of the solid-state imaging device according to the first embodiment of the present technology.
Fig. 3 is an exploded perspective view illustrating the configuration of the solid-state imaging device according to the first embodiment of the present technology.
Fig. 4 is an enlarged view of a portion B in Fig. 1.
Fig. 5 is a side cross-sectional view of another configuration example of a fragile portion according to the first embodiment of the present technology.
Fig. 6 is a diagram for describing a method for manufacturing the solid-state imaging device according to the first embodiment of the present technology.
Fig. 7 is a diagram for describing the method for manufacturing the solid-state imaging device according to the first embodiment of the present technology.
Fig. 8 is a diagram for describing how to handle a cover glass of the solid-state imaging device according to the first embodiment of the present technology.
Fig. 9 is a diagram for describing how to remove the cover glass of the solid-state imaging device according to the first embodiment of the present technology.
Fig. 10 is a plan view of a configuration of a modification of the solid-state imaging device according to the first embodiment of the present technology.
Fig. 11 is a side cross-sectional view of a configuration of a solid-state imaging device according to a second embodiment of the present technology.
Fig. 12 is a plan view of the configuration of the solid-state imaging device according to the second embodiment of the present technology.
Fig. 13 is an enlarged view of a portion D in Fig. 11.
Fig. 14 is a plan view of a configuration of a part of the solid-state imaging device according to the second embodiment of the present technology.
Fig. 15 is a diagram for describing how to remove a cover glass of the solid-state imaging device according to the second embodiment of the present technology.
Fig. 16 is a side cross-sectional view of a configuration of a modification of the solid-state imaging device according to the second embodiment of the present technology.
Fig. 17 is a plan view of the configuration of the modification of the solid-state imaging device according to the second embodiment of the present technology.
Fig. 18 is a diagram for describing how to remove a cover glass of the modification of the solid-state imaging device according to the second embodiment of the present technology.
Fig. 19 is a diagram for describing how to remove the cover glass of the modification of the solid-state imaging device according to the second embodiment of the present technology.
Fig. 20 is a perspective view of an extraction jig that is used to remove the cover glass of the modification of the solid-state imaging device according to the second embodiment of the present technology.
Fig. 21 is a plan view of a configuration of another modification of the solid-state imaging device according to the second embodiment of the present technology.
Fig. 22 is a side cross-sectional view of a configuration of a solid-state imaging device according to a third embodiment of the present technology.
Fig. 23 is a plan view of the configuration of the solid-state imaging device according to the third embodiment of the present technology.
Fig. 24 is an enlarged view of a portion G in Fig. 22.
Fig. 25 is a diagram illustrating a configuration of a cover glass according to the third embodiment of the present technology. Fig. 25A is a perspective view of the cover glass, Fig. 25B is a side view of the cover glass, and Fig. 25C is an H-directional arrow view of Fig. 25B.
Fig. 26 is a diagram for describing a method for manufacturing the solid-state imaging device according to the third embodiment of the present technology.
Fig. 27 is a diagram for describing how to remove the cover glass of the solid-state imaging device according to the third embodiment of the present technology.
Fig. 28 is a partially enlarged side cross-sectional view of a configuration of a first modification of the solid-state imaging device according to the third embodiment of the present technology.
Fig. 29 is a partially enlarged side cross-sectional view of a configuration of a second modification of the solid-state imaging device according to the third embodiment of the present technology.
Fig. 30 is a side cross-sectional view of a configuration of a third modification of the solid-state imaging device according to the third embodiment of the present technology.
Fig. 31 is a side cross-sectional view of a configuration of a solid-state imaging device according to a fourth embodiment of the present technology.
Fig. 32 is an enlarged view of a portion J in Fig. 31.
Fig. 33 is a diagram for describing how to remove a cover glass of the solid-state imaging device according to the fourth embodiment of the present technology.
Fig. 34 is a partially enlarged side cross-sectional view of a configuration of a modification of the solid-state imaging device according to the fourth embodiment of the present technology.
Fig. 35 is a block diagram illustrating a configuration example of an electronic device including the solid-state imaging device according to each embodiment of the present technology.

### MODE FOR CARRYING OUT THE INVENTION

The present technology is designed to make a cover member easy to remove from a package main body portion while keeping a support surface of the package main body portion that supports the cover member clean on the basis of a devised structure for attaching the cover member to the package main body portion.

Hereinafter, modes for carrying out the present technology (hereinafter referred to as "embodiments") will be described with reference to the drawings. Note that the drawings are schematic, and dimensional ratios and the like of the respective parts do not necessarily match actual ones. Furthermore, it is needless to say that dimensional relationships and ratios are partly different between the drawings. In the embodiments to be described below, an imaging device (solid-state imaging device) including a solid-state imaging element that is an example of a semiconductor element will be described as an example of a semiconductor device. Note that the embodiments will be described in the following order.
1. Configuration example of solid-state imaging device according to first embodiment
2. Method for manufacturing solid-state imaging device according to first embodiment
3. Use example of solid-state imaging device according to first embodiment
4. Modification of solid-state imaging device according to first embodiment
5. Configuration example of solid-state imaging device according to second embodiment
6. Use example of solid-state imaging device according to second embodiment
7. Modification of solid-state imaging device according to second embodiment
8. Configuration example of solid-state imaging device according to third embodiment
9. Method for manufacturing solid-state imaging device according to third embodiment
10. Use example of solid-state imaging device according to third embodiment
11. Modification of solid-state imaging device according to third embodiment
12. Configuration example of solid-state imaging device according to fourth embodiment
13. Use example of solid-state imaging device according to fourth embodiment
14. Modification of solid-state imaging device according to fourth embodiment
15. Configuration example of electronic device

### <1. Configuration example of solid-state imaging device according to first embodiment>

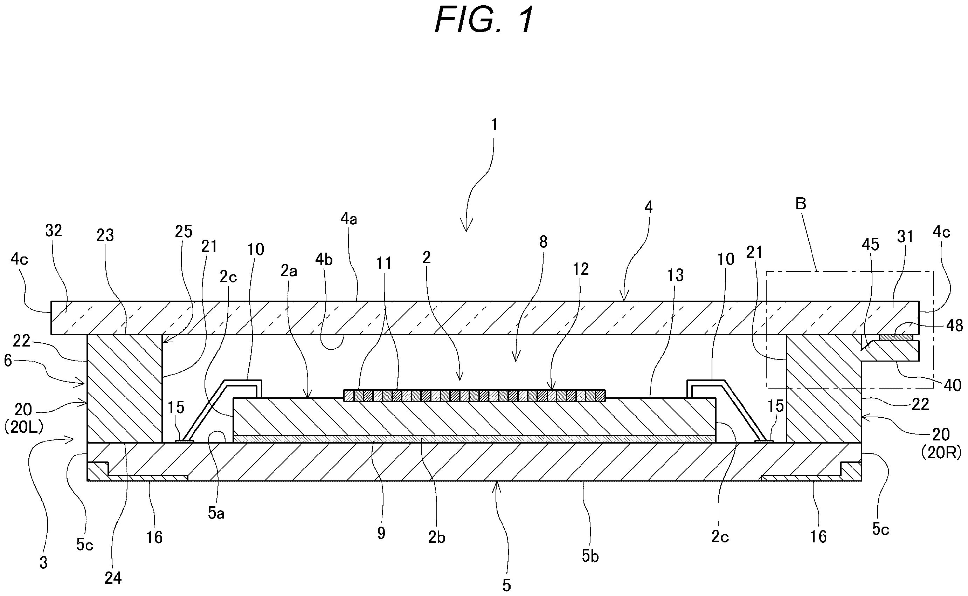

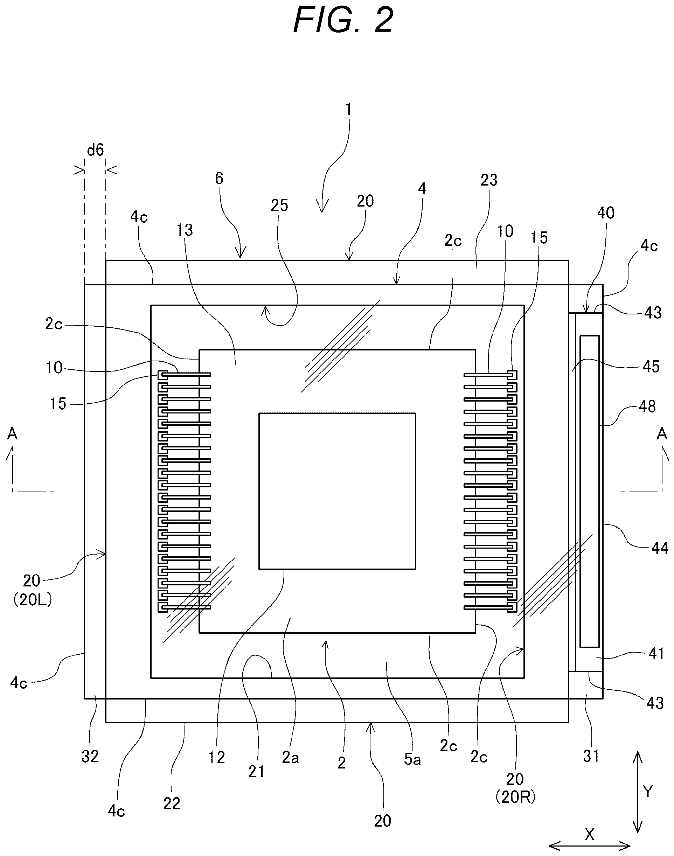

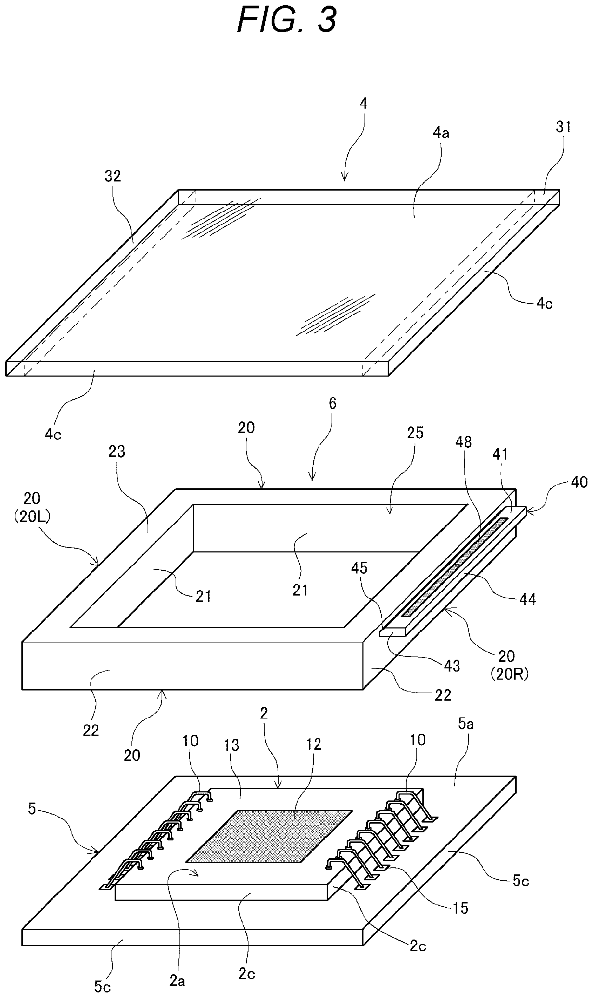

A configuration example of a solid-state imaging device according to a first embodiment of the present technology will be described with reference to Figs. 1 to 5. Note that the up-down of Fig. 1 refers to the up-down direction of a solid-state imaging device 1. Furthermore, Fig. 1 is a cross-sectional view taken along line A-A in Fig. 2.

As illustrated in Figs. 1 to 3, the solid-state imaging device 1 includes an image sensor 2 as a solid-state imaging element, a package main body portion 3 in which the image sensor 2 is installed, and a cover glass 4 as a transparent cover member. The package main body portion 3 includes a substrate 5 and a frame 6. Note that, in Fig. 2, a part that can be seen through the cover glass 4 is indicated by a solid line.

The solid-state imaging device 1 has a hollow package structure obtained by covering an upper opening portion of the box-shaped package main body portion 3 having the image sensor 2 as a semiconductor chip installed therein with the cover glass 4. That is, the solid-state imaging device 1 has, as a package structure, a structure in which the cover glass 4 is mounted on the substrate 5 with the frame 6 interposed between the cover glass 4 and the substrate 5, the substrate 5 having the image sensor 2 installed thereon, and a cavity 8 as a hollow portion is formed around the image sensor 2.

The substrate 5 is an interposer substrate, and is a flat member having a rectangular plate-shaped outline. The substrate 5 has a front surface 5a that is one plate surface on which the image sensor 2 is installed, a back surface 5b that is the other plate surface on the opposite side from the front surface 5a, and side surfaces 5c provided on the four sides. The image sensor 2 is die-bonded to the front surface 5a of the substrate 5. The image sensor 2 is bonded to the front surface 5a of the substrate 5 with a die bonding material 9 including an insulating or conductive adhesive or the like. Note that a plate thickness direction of the substrate 5 coincides with the up-down direction of the solid-state imaging device 1, and the front surface 5a side and the back surface 5b side coincide with the upper side and the lower side, respectively.

The substrate 5 is a ceramic substrate using ceramics such as alumina (Al₂O₃) or aluminum nitride (AlN) silicon nitride (Si₃N₄) as a base material, and is a circuit board on which a predetermined circuit pattern including a metal material is formed. Note that the substrate 5 may be, for example, another type of substrate such as an organic substrate using an organic material such as glass epoxy resin, which is a type of fiber-reinforced plastic, as a base material.

The image sensor 2 is a semiconductor element including a semiconductor substrate including silicon (Si) which is an example of a semiconductor. The image sensor 2 is a rectangular plate-shaped chip, a front surface 2a side which is one plate surface is a light receiving surface side, and the other plate surface on the opposite side is a back surface 2b. The image sensor 2 has side surfaces 2c provided on the four sides.

A plurality of light receiving elements (photoelectric conversion elements) is formed on the front surface 2a side of the image sensor 2. The image sensor 2 is a complementary metal oxide semiconductor (CMOS) image sensor. Note that the image sensor 2 may be another type of imaging element such as a charge coupled device (CCD) image sensor.

The image sensor 2 includes, on the front surface 2a side, a pixel region 12 that is a light receiving region in which a large number of pixels 11 are formed, and a peripheral region 13 that is a region around the pixel region 12. In the pixel region 12, the large number of pixels 11 are formed in a predetermined arrangement pattern such as a Bayer arrangement, and form a light receiving portion in the image sensor 2. A predetermined peripheral circuit is formed in the peripheral region 13. The pixels 11 each include a photodiode as a photoelectric converter having a photoelectric conversion function, and a plurality of pixel transistors.

On the front surface 2a side of the image sensor 2, a color filter and an on-chip lens are formed on the semiconductor substrate so as to correspond to each pixel 11 via an antireflection film, the antireflection film including an oxide film or the like, a planarization film including an organic material, and the like. Light incident on the on-chip lens passes through the color filter, the planarization film, and the like and is then received by the photodiode.

Note that the configuration of the image sensor 2 according to the present technology is not particularly limited. Examples of the configuration of the image sensor 2 include a front side illumination type in which the pixel region 12 is formed on the front surface side of the semiconductor substrate, a back side illumination type in which photodiodes and the like are arranged on the opposite side, and the back surface side of the semiconductor substrate serves as the light receiving surface side in order to improve light transmittance, and the like.

The substrate 5 and the image sensor 2 are electrically connected by a plurality of wires (bonding wires) 10 as connection members. The wires 10 are conductive wires and are thin metal wires including, for example, Au (gold), Cu (copper), Al (aluminum), or the like. Each wire 10 has one end connected to an electrode 15 formed on the front surface 5a of the substrate 5, and has the other end connected to an electrode formed in the peripheral region 13 of the front surface 2a of the image sensor 2, and these electrodes are electrically connected to each other.

The plurality of wires 10 is provided on the basis of the number of electrodes of the substrate 5 or the like. In the example illustrated in Fig. 2, the plurality of wires 10 is provided on a pair of sides, that is, the opposite sides, of the image sensor 2. Note that the plurality of wires 10 may be provided on the four sides of the image sensor 2. The electrode of the substrate 5 to which each wire 10 is connected is electrically connected to a plurality of terminal electrodes 16 formed on the back surface 5b side of the substrate 5 via a predetermined wiring portion formed in the substrate 5. For each terminal electrode 16, for example, a solder ball or the like is provided as a terminal for electrically connecting to a set board that is a circuit board on which the solid-state imaging device 1 is installed in an electronic device in which the solid-state imaging device 1 is mounted.

The frame 6 is a frame-shaped member, is provided on the substrate 5 so as to surround the image sensor 2, and forms a peripheral wall portion on the substrate 5. The frame 6 includes wall portions 20 provided on the four sides in a rectangular shape in plan view corresponding to the rectangular (or square) shape of the substrate 5 in plan view, and the wall portions 20 form a frame-shaped main body portion. Each wall portion 20 has a rectangular outline with the up-down direction as a longitudinal direction in side cross-sectional view (see Fig. 1). The wall portion 20 has an inner wall surface 21 that is a wall surface adjacent to the image sensor 2 and an outer wall surface 22 that is an outer wall surface on the opposite side from the inner wall surface 21.

The frame 6 is provided so as to make the outer wall surface 22 of each wall portion 20 flush with the side surface 5c of the substrate 5. Note that the frame 6 may be provided such that the outer wall surface 22 of each wall portion 20 is positioned inside or outside relative to the side surface 5c of the substrate 5.

The frame 6 has an upper surface as a glass support surface 23. The glass support surface 23 is a surface formed by the upper surface of each wall portion 20, and has a rectangular frame shape in plan view. The glass support surface 23 is formed as a plane located on a predetermined virtual plane perpendicular to the up-down direction. In the frame 6, the glass support surface 23 serves as a support surface that supports the cover glass 4. As described above, the frame 6 includes the wall portions 20 provided on the four sides that form the glass support surface 23 in a rectangular frame shape in plan view. Furthermore, the frame 6 has a lower surface 24 on the opposite side from the glass support surface 23.

The frame 6 has a rectangular opening portion 25 on the upper side. The opening portion 25 is formed by the inner wall surfaces 21 provided on the four sides corresponding to the outline of the frame 6 in plan view. In the frame 6, the glass support surface 23 forms an opening end surface of the opening portion 25.

The frame 6 is provided on the front surface 5a of the substrate 5 such that the lower surface 24 is positioned outside the electrode 15 to which the wire 10 is connected without coming into contact with the wire 10 and the electrode 15. The frame 6 is fixed on the front surface 5a of the substrate 5 with an adhesive such as an epoxy resin-based adhesive or an acrylic resin-based adhesive.

The frame 6 is a single member including, for example, a resin material such as an epoxy resin, a metal material such as stainless steel or copper (Cu), or ceramics. Furthermore, from the viewpoint of preventing reflection of light, for example, a low-reflection black resin material obtained by adding a black pigment such as carbon black or titanium black to resin such as a liquid crystal polymer or polyetheretherketone (PEEK) is used, and the frame 6 is manufactured by a known method such as injection molding or transfer molding. Note that the frame 6 is not limited to, for example, a configuration that includes only one kind of material, and may have a composite structure having a portion including a metal material and a portion including a resin material.

As described above, the package main body portion 3 includes the substrate 5 forming a substrate portion on which the image sensor 2 is installed, and the frame 6 provided on the upper side of the substrate 5 so as to surround the image sensor 2 and forming a frame portion having the opening portion 25 formed on the upper side. As described above, in the package main body portion 3, the frame 6 that is a component separate from the substrate 5 forming the substrate portion forms the frame portion. Note that the package main body portion 3 may include an integrated member such as a box-shaped package substrate having an upper side as an open side.

The cover glass 4 is an example of a transparent member, and is provided on the substrate 5 with the frame 6 interposed between the cover glass 4 and the substrate 5. The cover glass 4 has a rectangular plate-shaped outline and is larger in outline dimension than the image sensor 2. The cover glass 4 has an upper surface 4a that is an upper plate surface, a lower surface 4b that is a lower plate surface on the opposite side from the upper surface 4a and faces the image sensor 2, and side surfaces 4c provided on the four sides.

The cover glass 4 is provided above the image sensor 2 and closes the opening portion 25 with the cover glass 4 supported by the glass support surface 23 of the frame 6 forming the opening end surface of the opening portion 25 of the package main body portion 3. The cover glass 4 is provided on the frame 6 so as to be parallel to and spaced apart from the image sensor 2 on the light receiving surface side of the image sensor 2. The cover glass 4 has an outline dimension larger than an opening dimension of the opening portion 25, and is provided on the glass support surface 23 of the frame 6 to cover the entirety of the opening portion 25 from above.

The cover glass 4 transmits various kinds of light incident from the upper surface 4a side through an optical system such as a lens located above the cover glass 4. The light transmitted through the cover glass 4 reaches the light receiving surface of the image sensor 2 through the cavity 8. The cover glass 4 has a function of protecting the light receiving surface side of the image sensor 2. Note that, as the transparent member according to the present technology, for example, a plastic plate, a silicon plate, or the like may be used instead of the cover glass 4.

In the solid-state imaging device 1 having the above configuration, the light transmitted through the cover glass 4 passes through the cavity 8, and is received and detected by the light receiving elements constituting respective pixels 11 arranged in the pixel region 12 of the image sensor 2.

The solid-state imaging device 1 having the above configuration includes the following configuration for a fixing structure of the cover glass 4 fixed to the frame 6 forming the package main body portion 3. That is, the cover glass 4 has an overhanging portion (hereinafter, referred to as "glass overhanging portion") 31 that sticks out over the outline of the glass support surface 23 of the frame 6 in plan view, and is provided with the glass overhanging portion 31 fixed to the frame 6.

A dimension of the cover glass 4 in a longitudinal direction (a left-right direction in Fig. 2, hereinafter simply referred to as "longitudinal direction") of the rectangular outline is larger than a dimension of the frame 6 in the same direction. The cover glass 4 has one side (right side in Fig. 2) in the longitudinal direction projecting like an eave from the frame 6, and this projecting portion corresponds to the glass overhanging portion 31. Hereinafter, for convenience of description, the left-right direction and up-down in Fig. 2 are defined as an X direction (first direction) and a Y direction (second direction), respectively, orthogonal to each other when the solid-state imaging device 1 is viewed from above, and the left and right of Fig. 2 correspond to the left and right of the solid-state imaging device 1.

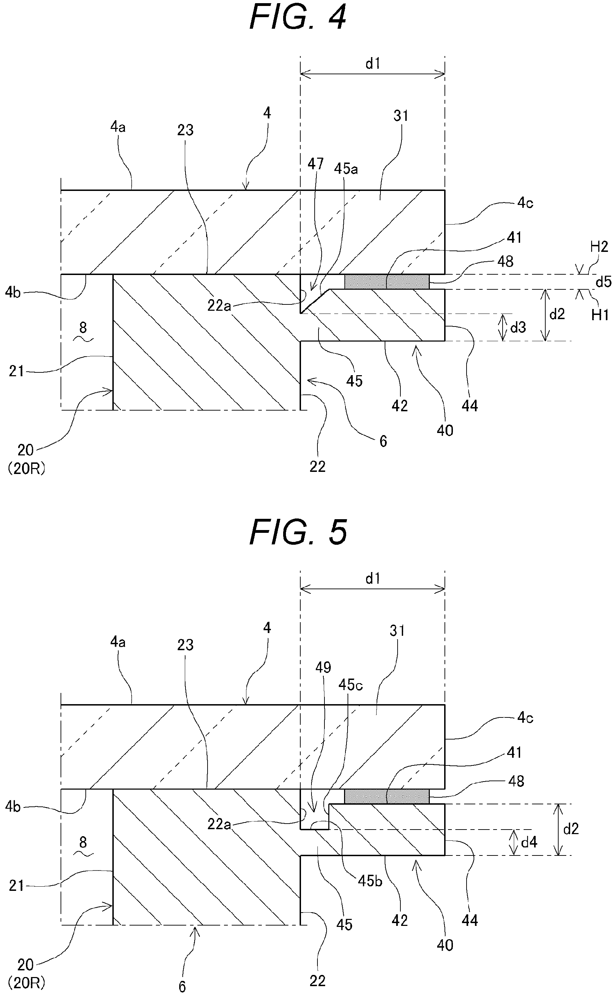

A right-edge portion of the cover glass 4 having a uniform width corresponds to the glass overhanging portion 31 sticking out relative to the frame 6. That is, the glass overhanging portion 31 is a portion of the cover glass 4 projecting rightward relative to the outer wall surface 22 of a right wall portion 20R of the four wall portions 20 of the frame 6, and is a portion having a predetermined width dimension d1 from the right side surface 4c (see Fig. 4). The width dimension d1 is a dimension in the X direction between the outer wall surface 22 of the wall portion 20R of the frame 6 and the right side surface 4c of the cover glass 4.

In the example illustrated in the drawing, the width dimension d1 of the glass overhanging portion 31 is about 1/15 of the dimension of the entirety of the cover glass 4 in the X direction. The size of the width dimension d1 of the glass overhanging portion 31 is not particularly limited.

As described above, in the solid-state imaging device 1, the glass overhanging portion 31 is provided as a portion along one side (right side) of the rectangular shape that is the outline of the glass support surface 23 of the frame 6 in plan view. The glass overhanging portion 31 of the cover glass 4 corresponds to a fixing portion fixed to the frame 6.

The frame 6 has a flange portion 40 as a portion to which the glass overhanging portion 31 is fixed. The flange portion 40 is formed as a part of the frame 6 by injection molding or the like. The flange portion 40 is an example of a cover fixing portion that is provided on the outer side of the wall portion 20R of the frame 6 and to which the glass overhanging portion 31 is fixed.

The flange portion 40 is a plate-shaped portion that is provided at an upper end portion of the wall portion 20R of the frame 6 and has an upper plate surface as a fixed surface 41 to which the glass overhanging portion 31 is fixed. The flange portion 40 has, corresponding to the glass overhanging portion 31, a narrow rectangular outline with the Y direction as the longitudinal direction in plan view. A projection width of the flange portion 40 projecting rightward from the wall portion 20R is the same as or approximately the same as the width dimension d1 of the glass overhanging portion 31.

The flange portion 40 has a lower surface 42 that is a plate surface on the opposite side from the fixed surface 41, end surfaces 43 on both sides in the Y direction, and a side surface 44 that is a right side surface. The flange portion 40 is formed as a portion having a uniform cross-sectional shape that is the same as the shape of the end surfaces 43 throughout the Y direction. The fixed surface 41 of the flange portion 40 is positioned at almost the same height as the glass support surface 23 of the frame 6. The side surface 44 of the flange portion 40 is flush with the right side surface 4c of the cover glass 4.

The flange portion 40 has a predetermined plate thickness d2 (see Fig. 4). The plate thickness d2 is a dimension in the up-down direction between the fixed surface 41 and the lower surface 42 of the flange portion 40. In the example illustrated in the drawing, the plate thickness d2 of the flange portion 40 is about 1/5 of the dimension of the entirety of the frame 6 in the up-down direction.

The flange portion 40 is continuously formed in the Y direction over an intermediate portion excluding both end portions in the Y direction of the outer wall surface 22 of the wall portion 20R. Furthermore, the flange portion 40 has a dimension in the Y direction smaller than a dimension in a short direction (the up-down direction in Fig. 2, hereinafter, simply referred to as "short direction") of the rectangular plate-shaped outline of the cover glass 4, and the end surfaces 43 on both sides are positioned inside relative to the side surfaces 4c on both sides of the cover glass 4 in the Y direction. Note that the flange portion 40 may be provided over a region corresponding to the glass overhanging portion 31 in the Y direction, or may be provided at a plurality of places at intervals, that is, discontinuously. Furthermore, the flange portion 40 may be provided at a corner portion of the frame 6.

Furthermore, the dimension of the cover glass 4 in the short direction is smaller than the dimension of the frame 6 in the Y direction, and the side surfaces 4c on both sides of the cover glass 4 in the short direction are each positioned on the glass support surface 23 of the frame 6. Note that the dimension of the cover glass 4 in the Y direction may be almost the same as the dimension of the frame 6 in the Y direction, or may be larger than the dimension of the frame 6 in the Y direction.

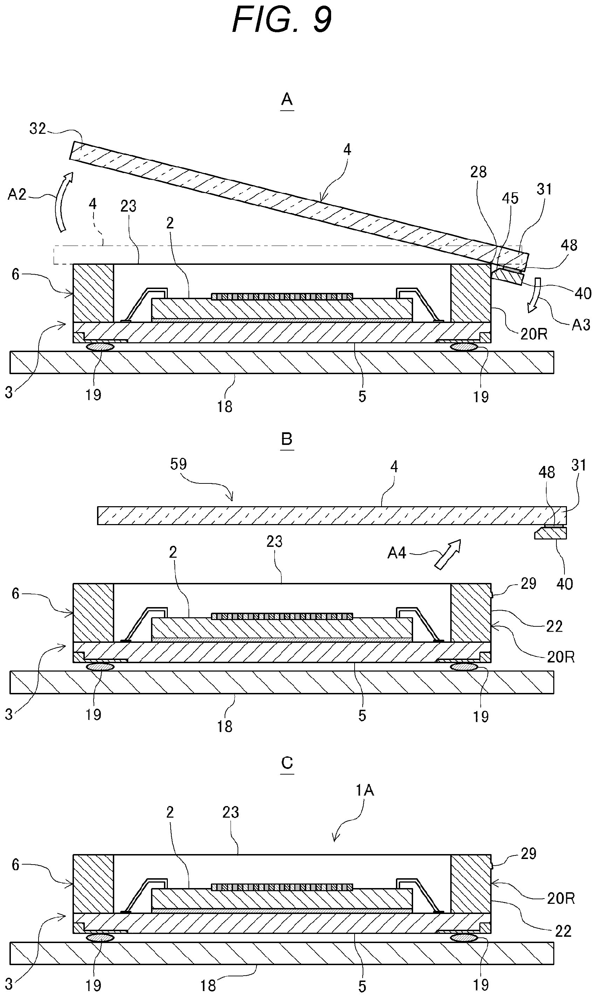

The flange portion 40 has a fragile portion 45 provided adjacent to the wall portion 20R of the frame 6 (on the left side) in the left-right direction, the fragile portion 45 being lower in stiffness in a direction in which the fragile portion 45 breaks downward (see an arrow A3 in Fig. 9). The fragile portion 45 is formed along a boundary between the flange portion 40 and the wall portion 20R. The fragile portion 45 has, on the upper surface side of the flange portion 40, an inclined surface 45a downwardly inclined from the side surface 44 side to the wall portion 20R side in the left-right direction (see Fig. 4).

The inclined surface 45a is a surface that gradually reduces the thickness of the flange portion 40 from the right side to the left side relative to the horizontal lower surface 42. The inclined surface 45a is formed with a uniform width in the left-right direction over the flange portion 40 in the Y direction. The inclined surface 45a has a dimension in the X direction of, for example, about 1/6 to 1/4 of the dimension in the width direction (width dimension d1) of the flange portion 40.

Since the flange portion 40 has the fragile portion 45, a groove portion 47 having a notch shape in side cross-sectional view is formed at the boundary between the wall portion 20R and the flange portion 40 (see Fig. 4). The groove portion 47 is a V-shaped groove portion formed by an upper edge portion 22a of the outer wall surface 22 of the wall portion 20R and the inclined surface 45a.

The fragile portion 45 makes a dimension in the up-down direction of a connection portion between the flange portion 40 and the outer wall surface 22 of the wall portion 20R smaller than the plate thickness d2 of the flange portion 40. In the example illustrated in Fig. 4, a dimension d3 in the up-down direction of the connection portion between the flange portion 40 and the wall portion 20R is about 1/2 of the plate thickness d2 of the main body portion of the flange portion 40.

The shape of the fragile portion 45 of the flange portion 40 is not limited to the shape according to the present embodiment. The fragile portion 45 may be any portion as long as the portion makes the base portion of the flange portion 40 easy to break from the wall portion 20R.

For example, as illustrated in Fig. 5, the fragile portion 45 may be a thin plate portion that is thinner than the main body portion of the flange portion 40 having the plate thickness d2. In such a configuration, on the upper surface side of the flange portion 40, as the upper surface of the fragile portion 45, a step surface 45b stepped downward relative to the fixed surface 41 forming the plate thickness d2 of the main body portion and an inner side surface 45c that is a surface facing the upper edge portion 22a of the outer wall surface 22 are formed.

Then, in the configuration illustrated in Fig. 5, the fragile portion 45 is a thin plate portion having a predetermined plate thickness d4 smaller than the plate thickness d2. The plate thickness d4 of the fragile portion 45 is a dimension in the up-down direction between the step surface 45b and the lower surface 42 of the flange portion 40. In the example illustrated in Fig. 5, the dimension of the plate thickness d4 of the fragile portion 45 is about 1/2 of the dimension of the plate thickness d2 of the flange portion 40.

In the configuration illustrated in Fig. 5, since the flange portion 40 has the fragile portion 45, a groove portion 49 having a cutout shape in side cross-sectional view is formed at the boundary between the wall portion 20R and the flange portion 40 (see Fig. 5). The groove portion 49 is a U-shaped groove portion formed by the upper edge portion 22a of the outer wall surface 22 of the wall portion 20R, the inclined surface 45a, and the step surface 45b.

The glass overhanging portion 31 of the cover glass 4 is fixed to the flange portion 40 as described above with an adhesive. That is, the glass overhanging portion 31 is fixed to the flange portion 40 by a joint portion 48 including the adhesive. The adhesive forming the joint portion 48 includes, for example, a thermosetting resin or a photocurable resin such as an ultraviolet (UV) curable resin.

The adhesive is linearly applied in a continuous pattern, with a predetermined width, to most of the fixed surface 41 of the flange portion 40 in the Y direction to form the joint portion 48. Note that the mode of applying the adhesive to the fixed surface 41, that is, the mode of forming the joint portion 48 is not particularly limited. As the mode of applying the adhesive to the fixed surface 41, for example, the adhesive may be linearly applied in a discontinuous pattern along the Y direction, may be applied in a plurality of parallel line patterns along the Y direction, or may be applied in a dotted pattern to a plurality of points. Furthermore, the application amount and the application area of the adhesive are set in accordance with the size and the like of the cover glass 4 so as to ensure retention force (adhesive force) required for the cover glass 4.

The cover glass 4 is fixed to the frame 6 at the flange portion 40 with the adhesive, and is placed and supported on the glass support surface 23 of the main body portion of the frame 6 in a non-adhered condition. That is, a part of the lower surface 4b of the cover glass 4 corresponding to the glass overhanging portion 31 is fixed, with the adhesive, to the fixed surface 41 of the flange portion 40, and a part other than the part corresponding to the glass overhanging portion 31 is a non-fixed contact surface that is in contact with the glass support surface 23 with no adhesive applied.

As described above, the glass overhanging portion 31 is fixed to the fixed surface 41 of the flange portion 40 by the joint portion 48 including the adhesive. In such a configuration, the flange portion 40 is provided so as to make the fixed surface 41 lower in position than the glass support surface 23 of the frame 6 by the thickness of the joint portion 48.

That is, as illustrated in Fig. 4, a height position H1 of the fixed surface 41 of the flange portion 40 is lower than a height position H2 of the glass support surface 23 by a thickness dimension d5 of the joint portion 48. Note that the fixed surface 41 is formed as a surface parallel to the glass support surface 23. The thickness dimension d5 of the joint portion 48 is, for example, about 15 to 20 µm.

Furthermore, the cover glass 4 has an opposite-side overhanging portion 32 that sticks out over the outline of the glass support surface 23 of the frame 6 in plan view provided on the opposite side from the glass overhanging portion 31. The cover glass 4 has the other side (left side in Fig. 2) in the longitudinal direction projecting like an eave from the frame 6, and this projecting portion corresponds to the opposite-side overhanging portion 32.

A left-edge portion of the cover glass 4 having a uniform width corresponds to the opposite-side overhanging portion 32 sticking out relative to the frame 6. That is, the opposite-side overhanging portion 32 is a portion of the cover glass 4 projecting leftward relative to the outer wall surface 22 of a left wall portion 20L of the four wall portions 20 of the frame 6, and is a portion projecting from the left side surface 4c by a predetermined width dimension d6 (see Fig. 2).

The width dimension d6 of the opposite-side overhanging portion 32 is a dimension in the X direction between the left outer wall surface 22 of the frame 6 and the left side surface 4c of the cover glass 4. In the example illustrated in the drawing, the width dimension d6 is about 1/2 of the width dimension d1 of the glass overhanging portion 31. The size of the width dimension d6 of the opposite-side overhanging portion 32 is not particularly limited, but the width dimension d6 is smaller than, for example, the width dimension d1 of the glass overhanging portion 31.

### <2. Method for manufacturing solid-state imaging device according to first embodiment>

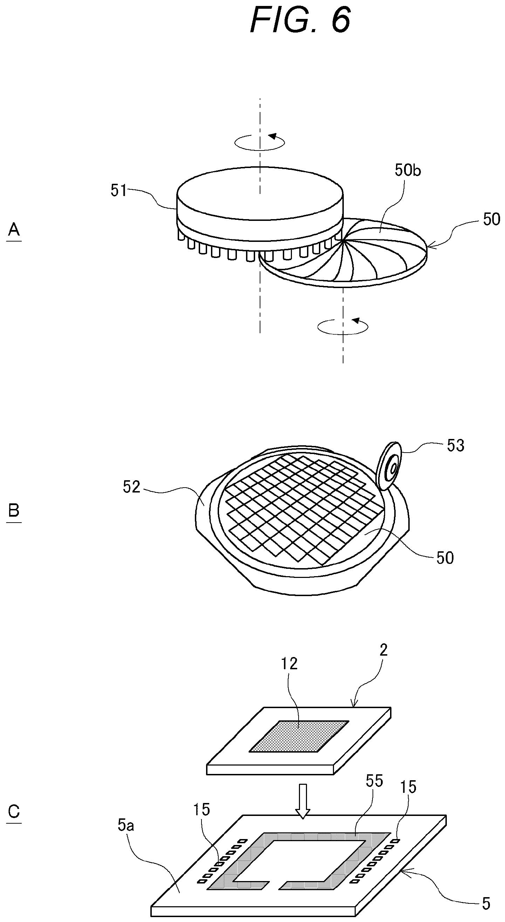

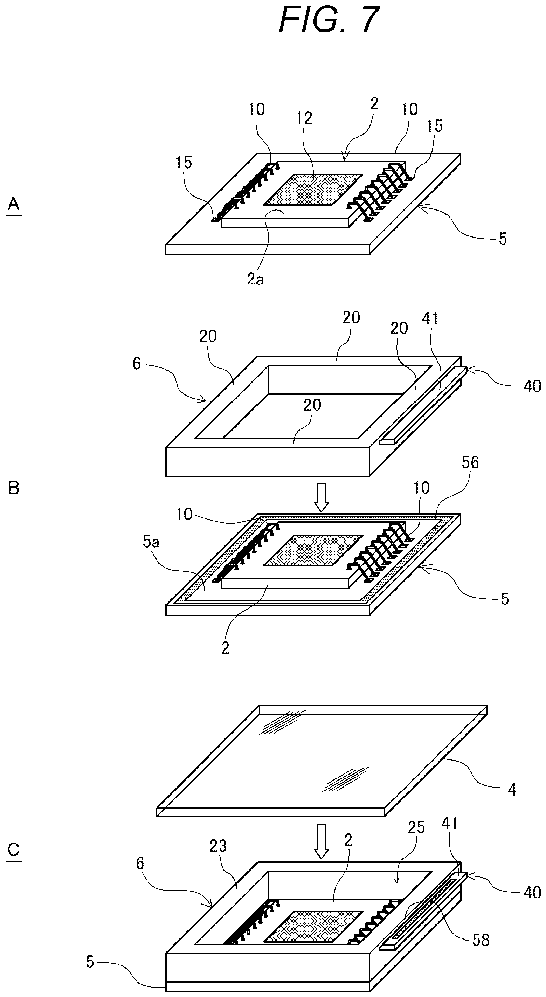

An example of a method for manufacturing the solid-state imaging device 1 according to the first embodiment of the present technology will be described with reference to Figs. 6 and 7.

First, as illustrated in Fig. 6A, a silicon wafer 50 having the pixel region 12 corresponding to each image sensor 2 formed on the front surface side is prepared. The silicon wafer 50 has undergone various processes for forming the image sensor 2. That is, the silicon wafer 50 is a semiconductor wafer in which a plurality of portions to be the image sensors 2 each having a pixel group formed on one plate surface side in a predetermined arrangement.

As illustrated in Fig. 6A, for the silicon wafer 50, a back-grinding (BG) process of grinding a back surface 50b side of the silicon wafer 50 is performed to set the silicon wafer 50 to a desired thickness that does not affect device characteristics. In the BG process, for example, a back grinding wheel 51 such as a diamond wheel is used to grind the silicon wafer 50.

Next, as illustrated in Fig. 6B, the silicon wafer 50 is diced along a predetermined dicing line. That is, a process of cutting, in accordance with the predetermined arrangement, the silicon wafer 50 into chips each corresponding to the image sensor 2 is performed. In the dicing process, the silicon wafer 50 set on a chuck table 52 is cut by a dicing blade 53 into separate chips each corresponding to the image sensor 2. As a result, the image sensors 2 as a large number of sensor chips are obtained.

Next, as illustrated in Fig. 6C, a process of setting the image sensor 2 obtained as a result of the dicing process on the substrate 5 is performed. That is, die bonding for die-bonding the image sensor 2 to the substrate 5 is performed. In this process, the image sensor 2 is bonded to a predetermined installation area on the front surface 5a of the substrate 5 with an adhesive 55 such as an insulating or conductive resin paste to be the die bonding material 9.

The adhesive 55 is applied onto the substrate 5 by a dispenser or the like. In the example illustrated in Fig. 6C, the adhesive 55 is applied in an approximately frame shape to conform to the outline of the image sensor 2. Note that the bonding portion to be the die bonding material 9 may be formed by patterning or the like using photolithography.

The image sensor 2 is mounted on the adhesive 55 applied onto the substrate 5 by a chip mounter or the like. Thereafter, a process of curing the adhesive 55 is performed in accordance with the material of the adhesive 55 and the like. For example, in a case where the adhesive 55 is thermosetting, a heating process (curing) for curing the adhesive 55 is performed. As a result, the image sensor 2 is fixed on the substrate 5.

Next, as illustrated in Fig. 7A, a process of setting the wire 10 that electrically connects the substrate 5 and the image sensor 2 is performed. Here, wire bonding of electrically connecting the electrode 15 of the substrate 5 and the electrode formed on the front surface 2a of the image sensor 2 using the wire 10 is performed.

Next, as illustrated in Fig. 7B, a frame mounting process of setting the frame 6 for supporting the cover glass 4 on the substrate 5 is performed. In the frame mounting process, the frame 6 having the flange portion 40 is prepared in advance by, for example, injection molding using a resin material such as an epoxy resin.

In the frame mounting process, as illustrated in Fig. 7B, after an adhesive 56 such as an epoxy resin-base adhesive is applied to a predetermined area of the front surface 5a of the substrate 5, the frame 6 is placed on the substrate 5 and fixed to the substrate 5. The adhesive 56 is applied in a frame shape over the entire perimeter along the outline of the substrate 5 so as to conform to the shape of the frame 6 in plan view. Note that the adhesive 56 may be applied to the frame 6. As a result of this process, the package main body portion 3 having a configuration where the frame 6 is set on the substrate 5 is obtained.

Then, as illustrated in Fig. 7C, a process of setting the cover glass 4 on the frame 6 is performed. The cover glass 4 is prepared by cutting a glass plate having a predetermined shape into a rectangular shape by dicing.

In this process, as illustrated n Fig. 7C, an adhesive 58 to be the joint portion 48 (see Fig. 1) is applied onto the fixed surface 41 of the flange portion 40 of the frame 6. Thereafter, the cover glass 4 is placed on the glass support surface 23 by a chip mounter or the like so as to close the opening portion 25 of the frame 6 from above. Here, regarding the application of the adhesive 58 onto the fixed surface 41, since the fixed surface 41 is almost flush with the glass support surface 23, an already available instrument for applying the adhesive to the glass support surface 23 of the frame 6 can be used, for example.

The adhesive 58 includes, for example, a thermosetting resin or a photocurable resin such as an ultraviolet (UV) curable resin. The adhesive 58 is applied in a predetermined amount and manner onto the fixed surface 41 so as to ensure adhesive force required for the cover glass 4. In the example illustrated in Fig. 7C, the adhesive 58 is linearly applied to the flange portion 40 along an extending direction of the flange portion 40. Note that the adhesive 58 may be applied to the cover glass 4 side. Furthermore, in a case where the adhesive 58 includes a photocurable resin, an adhesive that is cured by light in a wavelength band that is not absorbed by the cover glass 4 is used.

After the cover glass 4 is placed on the frame 6, a process of curing the adhesive 58 is performed in accordance with the material of the adhesive 58 and the like. In a case where the adhesive 58 includes a thermosetting material, a heating process (curing) for curing the adhesive 58 is performed. Furthermore, in a case where the adhesive 58 includes a UV-curable material, a process of irradiating the adhesive 58 with UV light is performed as the process for curing the adhesive 58. When the adhesive 58 is cured, the cover glass 4 is supported on the frame 6 with the cover glass 4 fixed to the flange portion 40 of the frame 6 by the joint portion 48.

As a result of the manufacturing processes described above, the solid-state imaging device 1 as illustrated in Figs. 1 and 2 is obtained. Note that, in the example of the manufacturing method described above, the frame mounting process of mounting the frame 6 on the substrate 5 is performed after the die bonding of the image sensor 2 and the wire bonding of the wire 10 are performed on the substrate 5, but the order of the processes may be reversed. That is, the frame mounting process of mounting the frame on the substrate 5 may be performed first, and then the process of die bonding and wire bonding may be performed.

### <3. Use example of solid-state imaging device according to first embodiment>

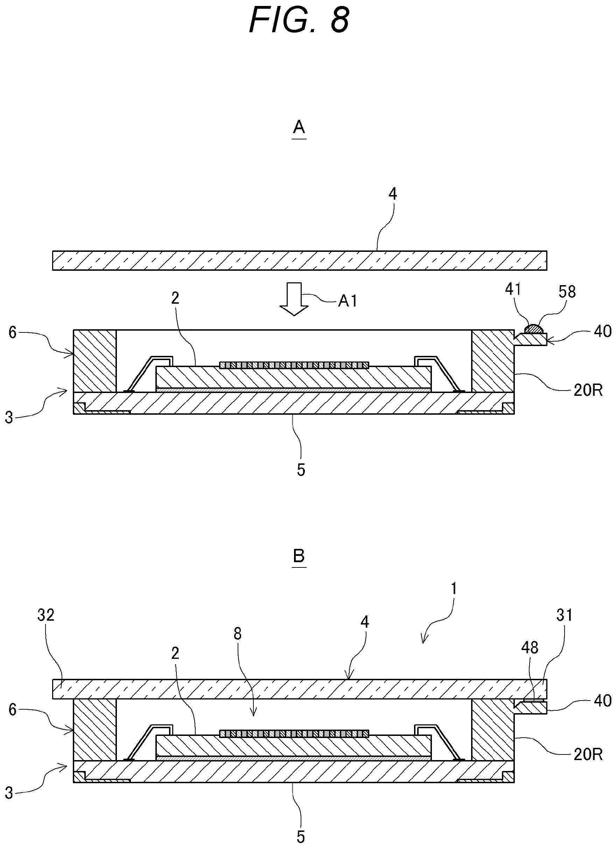

As a use example of the solid-state imaging device 1 according to the first embodiment of the present technology, how to handle the cover glass 4 will be described with reference to Figs. 8 and 9.

As illustrated in Fig. 8A, the cover glass 4 is fixed to the package main body portion 3 including the substrate 5 and the frame 6 as described above by the adhesive 58 applied to the fixed surface 41 of the flange portion 40 (see an arrow A1).

As illustrated in Fig. 8B, the solid-state imaging device 1 obtained by fixing the cover glass 4 to the package main body portion 3 is inspected for imaging by the image sensor 2, transported as a product, or installed on a set board with the cover glass 4 attached. Furthermore, the cover glass 4 is a member for making the handling of the solid-state imaging device 1 easier during a process of mounting a lens unit on the solid-state imaging device 1 or the like, or for preventing foreign matter from entering the inside of the package of the solid-state imaging device 1, for example.

On the other hand, for example, when the solid-state imaging device 1 is incorporated into a predetermined set structure constituting an electronic device such as a camera device, the cover glass 4 is removed from the package main body portion 3. That is, as one mode of use of the solid-state imaging device 1, the solid-state imaging device 1 is used with the cover glass 4 once attached to the package main body portion 3 removed.

For example, as illustrated in Fig. 9A, the cover glass 4 is removed with the solid-state imaging device 1 installed by reflow soldering on a set board 18 that is a circuit board having a predetermined circuit structure. The solid-state imaging device 1 is electrically connected to the set board 18 by solder balls 19 provided for the terminal electrodes 16.

In the solid-state imaging device 1, the cover glass 4 is removed from the package main body portion 3 by the following method. In order to remove the cover glass 4, from the state illustrated in Fig. 8B, the opposite-side overhanging portion 32 serves as a holding portion, and the opposite-side overhanging portion 32 of the cover glass 4 is lifted to tilt the cover glass 4 as illustrated in Fig. 9A (see an arrow A2), so that the flange portion 40 breaks from the main body portion of the frame 6. Details are as follows.

Regarding the lift of the cover glass 4 with the opposite-side overhanging portion 32 as a holding portion, since the cover glass 4 is not bonded to the glass support surface 23, which is the upper surface of the main body portion of the frame 6, the cover glass 4 is lifted without resistance to the main body portion of the frame 6. On the other hand, since the glass overhanging portion 31 of the cover glass 4 is bonded to the flange portion 40, the flange portion 40 tilts together with the lifted cover glass 4.

When the opposite-side overhanging portion 32 of the cover glass 4 is lifted, the glass overhanging portion 31 side of the cover glass 4 is lowered by the principle of leverage with an upper right corner portion 28 of the wall portion 20R as a fulcrum, and the flange portion 40 receives, from the cover glass 4, a force pushing downward (see an arrow A3), for example. Then, when the cover glass 4 tilts to a certain angle, the flange portion 40 breaks downward from the wall portion 20R.

Since the flange portion 40 has the fragile portion 45, the flange portion 40 breaks at the base portion side (the wall portion 20R side) with the fragile portion 45 as a starting point and is entirely or almost entirely separated from the wall portion 20R. Here, in order to separate the flange portion 40 from the wall portion 20R, a reciprocating operation of lifting and pressing the cover glass 4 is performed as needed.

As illustrated in Fig. 9B, when the flange portion 40 is separated from the wall portion 20R, the cover glass 4 is removed from the package main body portion 3 together with the flange portion 40 bonded to the glass overhanging portion 31 (see an arrow A4). That is, the component separated from the package main body portion 3 becomes an integrated separate body 59 including the flange portion 40 fixed, via the joint portion 48, to the right edge portion used to be the glass overhanging portion 31 in relation to the frame 6.

As a result, as illustrated in Fig. 9C, a solid-state imaging device 1A corresponding to the solid-state imaging device 1 from which the cover glass 4 has been removed is obtained. In the solid-state imaging device 1A, for example, on the outer wall surface 22 of the wall portion 20R, a mark 29 indicating the removal of the flange portion 40 exists as a fixation mark of the cover glass 4. The mark 29 is a separation portion of the resin member forming the frame 6, and becomes a portion slightly projecting from the outer wall surface 22 in a manner that depends on how the flange portion 40 breaks.

According to one aspect of the method for using the solid-state imaging device 1 as described above, the following method is used as a method for manufacturing an electronic device. That is, the method for manufacturing an electronic device includes a process of removing the cover glass 4 together with the flange portion 40 from the frame 6 of the package main body portion 3 by lifting the cover glass 4 like opening a lid, and a process of attaching the solid-state imaging device 1A from which the cover glass 4 has been removed to a predetermined attachment area of the electronic device.

The solid-state imaging device 1 according to the present embodiment as described above makes the cover glass 4 easy to remove without leaving, with the cover glass 4 removed from the package main body portion 3, the adhesive for fixing the cover glass 4 on the glass support surface 23 of the package main body portion 3.

In the solid-state imaging device 1, in order to fix the cover glass 4 to the package main body portion 3, the glass overhanging portion 31 is fixed to the flange portion 40 provided on the outer side of the main body portion of the frame 6. Such a configuration eliminates the need of forcibly taking off the bonding portion and makes, by lifting the cover glass 4 to separate the flange portion 40 together with the cover glass 4, the cover glass 4 easy to remove without using a tool, an instrument, or the like. As described above, with the solid-state imaging device 1, it is possible to implement an image sensor package from which the cover glass 4 is easily removed.

Furthermore, since no adhesive is applied to the glass support surface 23 of the frame 6 on which the cover glass 4 is placed and supported, there is no possibility that the adhesive remains as a residue on the glass support surface 23 with the cover glass 4 removed, and the glass support surface 23 can be kept clean. It is therefore possible for the solid-state imaging device 1A without glass to use the glass support surface 23 as, for example, a joint surface to be joined to a casing or the like of the set structure, a guide plane used in tilt adjustment (adjustment of the tilt of the imaging surface) when the solid-state imaging device 1A is attached to the set structure, or a joint surface of a new component to be joined to the package main body portion 3.

Furthermore, since no adhesive remains on the glass support surface 23, it is possible to prevent an adhesive from adhering to the image sensor 2 inside the package as dust after the solid-state imaging device 1A is incorporated into the set. This prevents the imaging surface of the image sensor 2 from being contaminated, so that it is possible to make the performance of the image sensor 2 high enough.

Furthermore, the fixing structure of the cover glass 4 according to the present embodiment eliminates the need of removing the cover glass 4 in advance when the solid-state imaging device 1 is installed by reflow soldering on the set board, so that the installation by reflow soldering can be performed with the cover glass 4 attached. This allows the image sensor 2 to be covered with the cover glass 4 during reflow soldering, so that it is possible to prevent the image sensor 2 from being contaminated. Furthermore, since there is no need to increase the number of steps for attaching the cover glass 4, it is possible to achieve the fixing structure of the cover glass 4 that can be easily removed without reducing productivity.

Moreover, the fixing structure of the cover glass 4 according to the present embodiment prevents the opening portion 25 of the frame 6 from being tightly covered by the cover glass 4, so that it is possible to suppress an increase in stress generated by vapor pressure in the cavity 8 of the package during reflow soldering by which the solid-state imaging device 1 is installed on the set board. It is therefore possible to prevent cracks of the cover glass 4, disconnection of the wire 10, or the like due to the installation by reflow soldering.

Furthermore, in the present embodiment, the glass overhanging portion 31 is a portion extending along one side of the rectangular outline of the cover glass 4, and the package main body portion 3 has the flange portion 40 provided on one side of the frame 6 as a portion to which the glass overhanging portion 31 is fixed. Such a configuration allows a general rectangular plate-shaped glass material to be used as the cover glass 4, so that it is possible to achieve, in a relatively simple manner, the fixing structure for the package main body portion 3 using the glass overhanging portion 31.

Furthermore, the flange portion 40 of the frame 6 to which the glass overhanging portion 31 is fixed is a plate-shaped portion having the upper plate surface as the fixed surface 41. Such a configuration makes the flange portion 40 to be separated from the main body portion of the frame 6 together with the cover glass 4 relatively easy to break, thereby allowing the cover glass 4 to be easily removed.

Furthermore, the flange portion 40 has the fragile portion 45. Such a configuration makes the flange portion 40 easy to break at the area where the fragile portion 45 is formed in response to the operation of lifting the cover glass 4. In particular, providing the fragile portion 45 at the base portion of the flange portion 40 allows the flange portion 40 to break at the base portion and can prevent a part of the flange portion 40 from remaining on the main body portion (wall portion 20R) side of the frame 6.

Furthermore, the flange portion 40 is provided so as to make the fixed surface 41 lower in height position than the glass support surface 23 by the thickness of the joint portion 48. Such a configuration can keep the cover glass 4 level, and can achieve a state where the lower surface 4b of the cover glass 4 is entirely in contact with the glass support surface 23 of the frame 6. It is therefore possible to support the cover glass 4 in a stable state relative to the frame 6. Furthermore, since the cover glass 4 can be entirely brought into close contact with the glass support surface 23, it is possible to prevent, for example, the entry of dust into the package during transportation of the solid-state imaging device 1, reflow soldering to the set board, or the like. Note that the flange portion 40 may be provided so as to make the fixed surface 41 identical in height position to the glass support surface 23, that is, to position the fixed surface 41 on a horizontal plane common to the glass support surface 23.

Furthermore, the cover glass 4 has the opposite-side overhanging portion 32 on the opposite side from the glass overhanging portion 31. Such a configuration allows the opposite-side overhanging portion 32 to be used as a holding portion for the removal of the cover glass 4, thereby making the handling of the cover glass 4 easy when the operation of lifting the cover glass 4 is performed. Note that the cover glass 4 may have, for example, overhanging portions sticking out relative to the frame 6 provided on both sides in the Y direction, and the overhanging portions may be used as a gripping portion of the cover glass 4 for the operation of lifting the cover glass 4. At least a part of the cover glass 4 on the opposite side from the glass overhanging portion 31 is used as an overhanging portion sticking out relative to the frame 6, so that the overhanging portion can be used as a holding portion when the cover glass 4 is removed.

### <4. Modification of solid-state imaging device according to first embodiment>

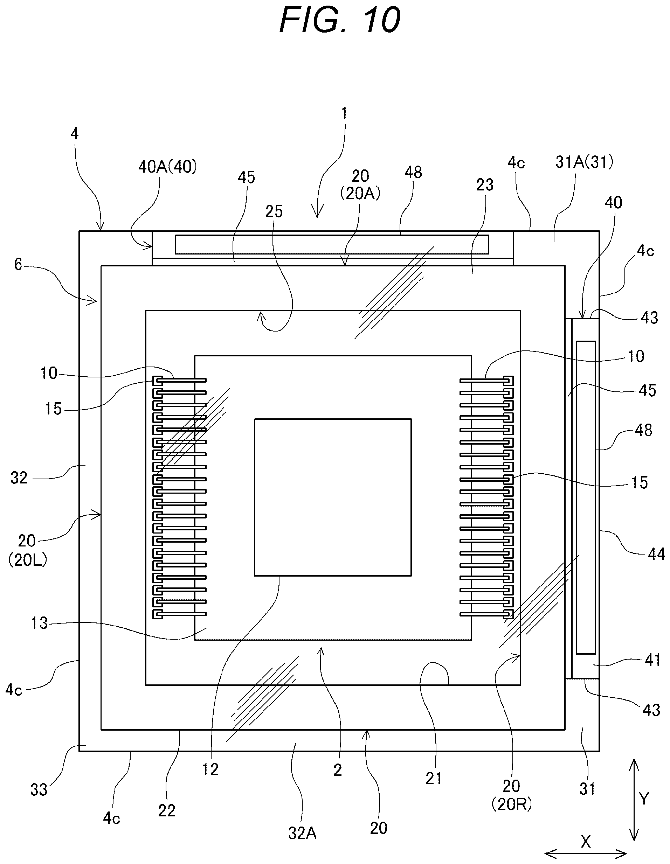

A modification of the solid-state imaging device 1 according to the first embodiment of the present technology will be described with reference to Fig. 10. As illustrated in Fig. 10, according to this modification, in the solid-state imaging device 1 having a rectangular outline in plan view, the fixing portion (hereinafter, as "glass fixing portion") where the glass overhanging portion 31 is bonded and fixed to the flange portion 40 is provided on not only the right side but also one side in the Y direction (upper side in Fig. 10). That is, the glass fixing portion is provided along two adjacent sides of the outline of the cover glass 4 in plan view.

As illustrated in Fig. 10, the cover glass 4 having a rectangular plate-shaped outline has one side in the Y direction projecting like an eave from the frame 6, and this projecting portion corresponds to a glass overhanging portion 31A. Furthermore, the frame 6 has a flange portion 40A to which the glass overhanging portion 31A is fixed provided on the outer side of a wall portion 20A that is one side in the Y direction. Then, the glass overhanging portion 31A of the cover glass 4 is fixed to the flange portion 40A by the joint portion 48 including an adhesive.

Furthermore, in the configuration of this modification, the cover glass 4 has an opposite-side overhanging portion 32A that sticks out over the outline of the glass support surface 23 of the frame 6 in plan view provided on the opposite side from the glass overhanging portion 31A. The cover glass 4 has the other side (lower side in Fig. 10) in the Y direction projecting like an eave from the frame 6, and this projecting portion corresponds to the opposite-side overhanging portion 32A.

In the configuration of the modification illustrated in Fig. 10, the cover glass 4 is removed by, for example, lifting the cover glass 4 using at least one of the opposite-side overhanging portion 32 on the left side of the cover glass 4 or the opposite-side overhanging portion 32A on the other side in the Y direction of the cover glass 4 as a holding portion. For example, the cover glass 4 is lifted in a diagonal direction using a corner portion 33 formed by the opposite-side overhanging portion 32 and the opposite-side overhanging portion 32A as a holding portion. This causes the two flange portions 40 to simultaneously break at their respective fragile portions 45 to be removed from the package main body portion 3 together with the cover glass 4.

As in the configuration of this modification, providing the glass fixing portion on the two adjacent sides of the cover glass 4 allows an increase in adhesive strength between the cover glass 4 and the package main body portion 3. It is therefore possible to prevent the cover glass 4 from being unintentionally separated during transportation of the solid-state imaging device 1 or the like.

As described above, the glass overhanging portion 31 forming the glass fixing portion may be provided as a portion along a plurality of sides of the outline of the glass support surface 23 of the frame 6 in plan view. That is, the glass overhanging portion 31 may be a portion along at least one side of the outline of the glass support surface 23 in plan view.

Therefore, the glass fixing portion may be provided on three sides or four sides of the rectangular outline of the glass support surface 23 in plan view. Furthermore, the configuration where the glass fixing portions are provided on two sides is not limited to the configuration where the glass fixing portion is provided on two adjacent sides as illustrated in Fig. 10, and may be a configuration where the glass fixing portions are provided on two opposite sides.

### <5. Configuration example of solid-state imaging device according to second embodiment>

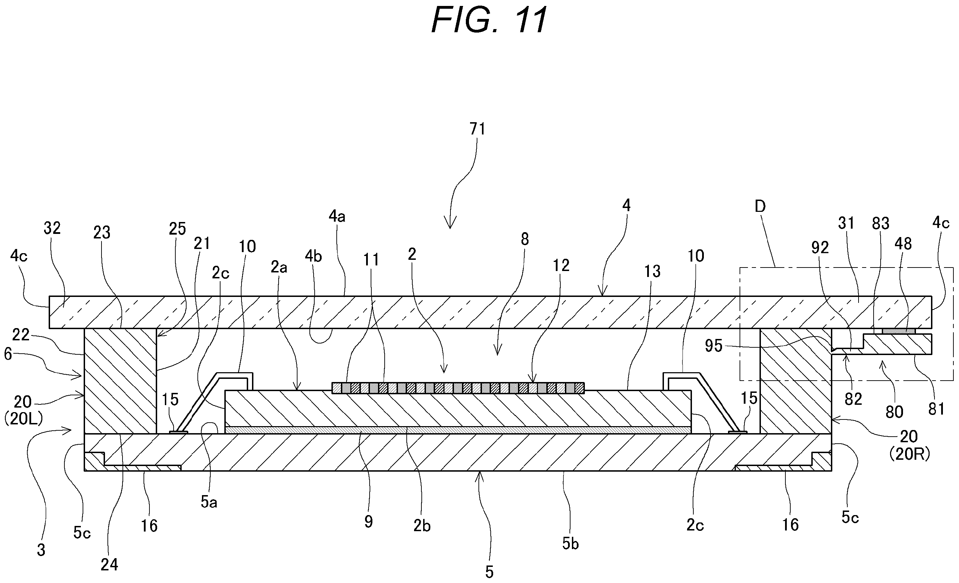

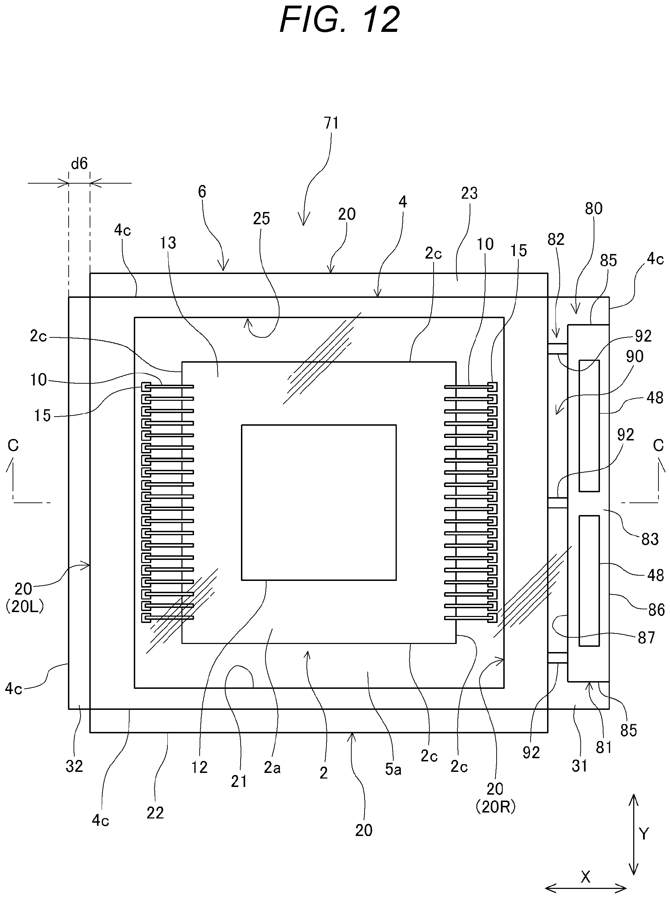

A configuration example of a solid-state imaging device 71 according to a second embodiment of the present technology will be described with reference to Figs. 11 to 14. Note that Fig. 11 is a cross-sectional view taken along line C-C in Fig. 12. In each embodiment to be described below, the same names or the same reference numerals are used for components common to or corresponding to components of the first embodiment, and the description of the components will be omitted as appropriate.

The solid-state imaging device 71 according to the present embodiment is different from the solid-state imaging device 1 according to the first embodiment in the configuration of the cover fixing portion of the frame 6 to which the glass overhanging portion 31 is fixed.

As illustrated in Figs. 11 to 14, a flange portion 80 as the cover fixing portion according to the present embodiment has a flange main body portion 81 as a main body portion provided at a position spaced apart from the wall portion 20R of the frame 6 by a gap 90, and a connecting portion 82 that connects the flange main body portion 81 and the wall portion 20R and is lower in stiffness than the flange main body portion 81. The flange portion 80 is formed as a part of the frame 6 by injection molding or the like.

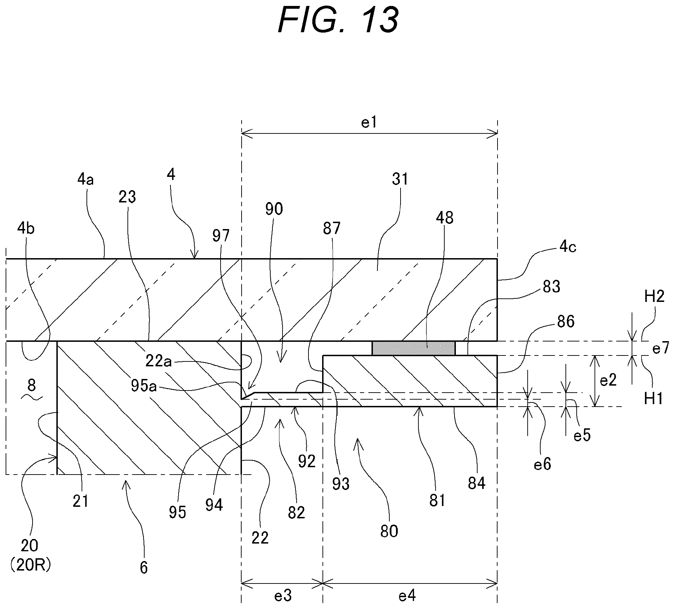

The flange portion 80 is provided at an outer upper end of the wall portion 20R of the frame 6. A projection width of the flange portion 80 projecting rightward from the wall portion 20R is the same as or almost the same as a width dimension e1 of the glass overhanging portion 31 (see Fig. 13).

The flange main body portion 81 is a plate-shaped or quadrangular prism portion extending in the Y direction, and has an upper surface as a fixed surface 83 to which the glass overhanging portion 31 is fixed. The flange main body portion 81 has, corresponding to the glass overhanging portion 31, a narrow rectangular outline with the Y direction as the longitudinal direction in plan view.

The flange main body portion 81 has a lower surface 84 that is a plate surface on the opposite side from the fixed surface 83, end surfaces 85 on both sides in the Y direction, an outer side surface 86 that is a right side surface, and an inner side surface 87 that is a left side surface. The flange main body portion 81 is formed as a portion having a uniform cross-sectional shape that is the same as the shape of the end surfaces 85 throughout the Y direction. The fixed surface 83 of the flange main body portion 81 is positioned at almost the same height as the glass support surface 23 of the frame 6. The outer side surface 86 of the flange main body portion 81 is flush with the right side surface 4c of the cover glass 4.

The flange main body portion 81 has a predetermined plate thickness e2 (see Fig. 13). The plate thickness e2 is a dimension in the up-down direction between the fixed surface 83 and the lower surface 84 of the flange main body portion 81. In the example illustrated in the drawing, the plate thickness e2 of the flange main body portion 81 is about 1/5 of the dimension of the entirety of the frame 6 in the up-down direction.

The flange main body portion 81 is continuously formed in the Y direction over an intermediate portion excluding both ends in the Y direction of the outer wall surface 22 of the wall portion 20R. Furthermore, the flange main body portion 81 has a dimension in the Y direction smaller than a dimension of the cover glass 4 in the short direction, and the end surfaces 85 on both sides are positioned inside relative to the side surfaces 4c on both sides of the cover glass 4 in the Y direction. Note that the flange main body portion 81 may be provided over a region in the Y direction corresponding to the entirety of the glass overhanging portion 31, or may be provided at a plurality of places at intervals, that is, discontinuously.

The flange main body portion 81 has the inner side surface 87 facing the outer wall surface 22 of the wall portion 20R, and is spaced apart from the wall portion 20R by the gap 90. The gap 90 is a space between the outer wall surface 22 of the wall portion 20R and the inner side surface 87 of the flange main body portion 81. In the example illustrated in Fig. 13, a dimension e3 of the gap 90 is about 1/2 of a width dimension e4 of the flange main body portion 81.

The connecting portion 82 is a portion of the flange portion 80 provided adjacent to the wall portion 20R relative to (on the left side of) the flange main body portion 81. The connecting portion 82 is a portion that is lower in stiffness in a direction in which the flange portion 80 vertically breaks, and is a fragile portion fragile as compared to the flange main body portion 81.

In the present embodiment, the connecting portion 82 includes a plurality of rib portions 92 provided at predetermined intervals in the direction (Y direction) of the right side of the glass support surface 23. The rib portion 92 is a thin plate portion thinner than the flange main body portion 81 having the plate thickness e2.

The rib portion 92 is provided at three places: both end portions and a center portion of the flange main body portion 81 in the Y direction. The rib portion 92 is a portion narrow (thin) enough as compared to the long flange main body portion 81 in the Y direction. The length (dimension in the X direction) of the rib portion 92 coincides with the dimension e3 of the gap 90 (see Fig. 13).

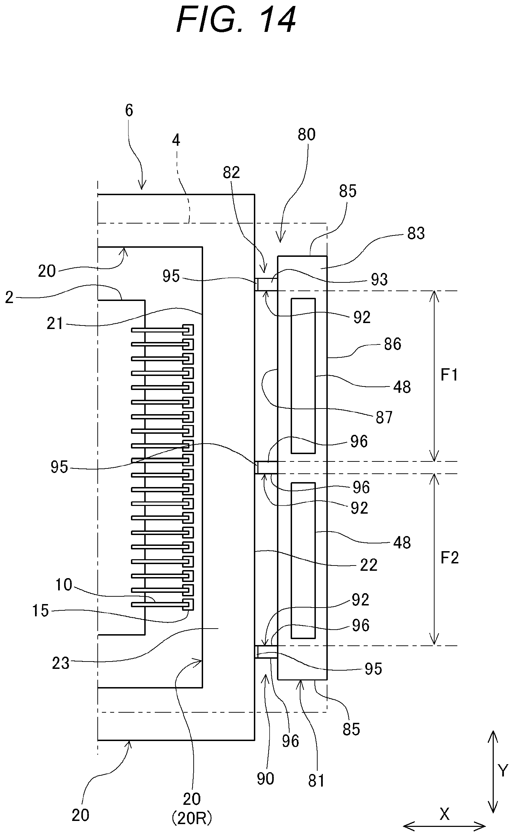

The rib portion 92 has an upper surface 93 that is an upper plate surface and a lower surface 94 that is a lower plate surface (see Fig. 13). The rib portion 92 horizontally projects leftward from a lower edge portion of the inner side surface 87 of the flange main body portion 81 so as to make the lower surface 94 flush with the lower surface 84 of the flange main body portion 81. Furthermore, the rib portion 92 has side surfaces 96 on both sides in the Y direction (see Fig. 14). The rib portion 92 has a predetermined plate thickness e5 smaller than the plate thickness e2 of the flange main body portion 81. In the example illustrated in Fig. 13, the dimension of the plate thickness e5 of the rib portion 92 is about 1/4 of the dimension of the plate thickness e2 of the flange main body portion 81.

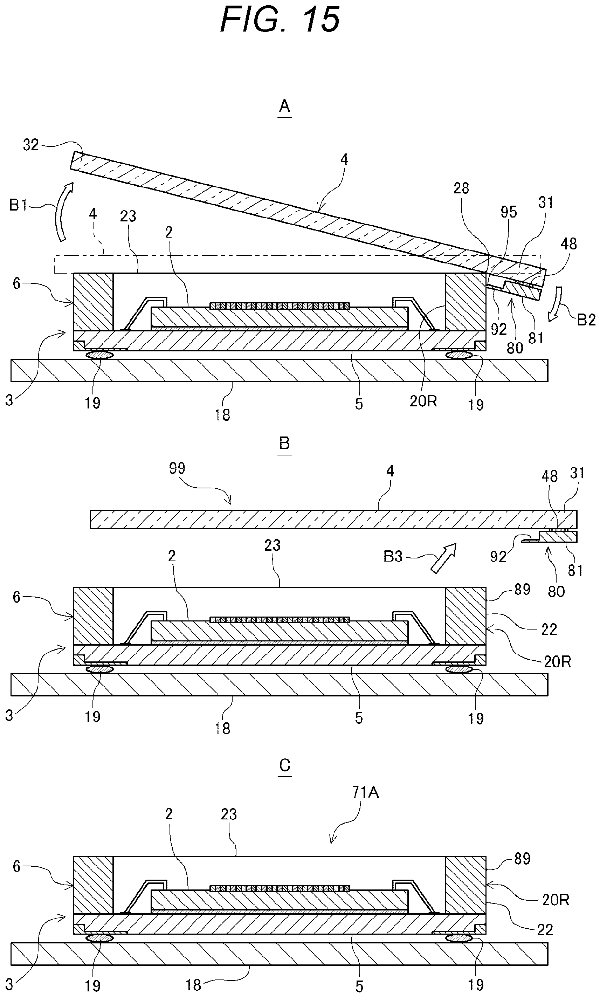

The rib portion 92 has a fragile portion 95 provided adjacent to the wall portion 20R of the frame 6 (on the light side) in the left-right direction, the fragile portion 95 being lower in stiffness in a direction in which the fragile portion 95 breaks downward (see an arrow B2 in Fig. 15). The fragile portion 95 has, on the upper surface side of the rib portion 92, an inclined surface 95a downwardly inclined from the flange main body portion 81 side to the wall portion 20R side in the left-right direction (see Fig. 13).

The inclined surface 95a is a surface that gradually reduces the thickness of the rib portion 92 from the right side to the left side relative to the horizontal lower surface 94. The inclined surface 95a has a dimension of, for example, about 1/6 to 1/4 of the length dimension of the rib portion 92 in the X direction.

Since the rib portion 92 has the fragile portion 95, a groove portion 97 having a notch shape in side cross-sectional view is formed at a boundary between the wall portion 20R and the rib portion 92 (see Fig. 13). The groove portion 97 is a V-shaped groove portion formed by the upper edge portion 22a of the outer wall surface 22 of the wall portion 20R and the inclined surface 95a.

The fragile portion 95 makes a dimension in the up-down direction of a connection portion between the rib portion 92 and the outer wall surface 22 of the wall portion 20R smaller than the plate thickness e5 of the rib portion 92. In the example illustrated in Fig. 13, a dimension e6 in the up-down direction of the connection portion between the rib portion 92 and the wall portion 20R is about 1/2 of the plate thickness e5 of the rib portion 92.

The shape of the fragile portion 95 of the rib portion 92 is not limited to the shape according to the present embodiment. The fragile portion 95 may be any portion as long as the portion makes the base portion of the flange portion 80 easy to break from the wall portion 20R. The fragile portion 95 may be, for example, a thin plate portion smaller in thickness than the rib portion 92.

The glass overhanging portion 31 of the cover glass 4 is fixed to the flange portion 80 as described above with an adhesive. That is, the glass overhanging portion 31 is fixed to the flange main body portion 81 of the flange portion 80 by the joint portion 48 including the adhesive.

The adhesive is linearly applied to most of the fixed surface 83 of the flange main body portion 81 in the Y direction to form the joint portion 48. In the present embodiment, the adhesive forming the joint portion 48 is applied, in the Y direction, to a portion other than the area where the rib portion 92 is formed, that is, an area where no rib portion 92 is formed.

Specifically, as illustrated in Fig. 14, on the fixed surface 83 of the flange main body portion 81, the adhesive forming the joint portion 48 is applied to a first region F1 and a second region F2 in the Y direction. The first region F1 is a region between the rib portion 92 on one end side (upper side in Fig. 14) and the center rib portion 92. The second region F2 is a region between the rib portion 92 on the other end side (lower side in Fig. 14) and the center rib portion 92. The first region F1 and the second region F2 are regions between the side surfaces 96 facing each other of the rib portions 92 adjacent to each other in the Y direction.

For each of the first region F1 and the second region F2 on the fixed surface 83, the joint portion 48 is linearly applied, along the Y direction, to most of the region excluding both ends in the Y direction with a predetermined width. A region other than the first region F1 and the second region F2 on the fixed surface 83 is a region where no adhesive is applied.

As described above, on the fixed surface 83 of the flange main body portion 81, the joint portion 48 including the adhesive for fixing the glass overhanging portion 31 is provided over the area where no rib portion 92 is formed in the extending direction (Y direction) of the flange main body portion 81. Note that the mode of applying the adhesive to the fixed surface 83, that is, the mode of forming the joint portion 48 is not particularly limited.

Furthermore, in a manner similar to the first embodiment, the flange portion 80 is provided so as to make the fixed surface 83 of the flange main body portion 81 lower in position than the glass support surface 23 by the thickness of the joint portion 48. That is, as illustrated in Fig. 13, a height position H1 of the fixed surface 83 of the flange main body portion 81 is lower than a height position H2 of the glass support surface 23 by a thickness dimension e7 of the joint portion 48.

### <6. Use example of solid-state imaging device according to second embodiment>

As a use example of the solid-state imaging device 71 according to the second embodiment of the present technology, how to remove the cover glass 4 will be described with reference to Fig. 15. In the solid-state imaging device 71, the cover glass 4 is removed in a manner similar to the first embodiment.

In order to remove the cover glass 4, from the state illustrated in Fig. 11, the opposite-side overhanging portion 32 serves as a holding portion, and the opposite-side overhanging portion 32 of the cover glass 4 is lifted to tilt the cover glass 4 as illustrated in Fig. 15A (see an arrow B1), so that the flange portion 80 breaks from the main body portion of the frame 6.

Regarding the lift of the cover glass 4 with the opposite-side overhanging portion 32 as a holding portion, since the glass overhanging portion 31 of the cover glass 4 is bonded to the flange portion 80, the flange portion 80 tilts together with the lifted cover glass 4. Note that since the cover glass 4 is not bonded to the glass support surface 23, the cover glass 4 is lifted without resistance to the main body portion of the frame 6.

When the opposite-side overhanging portion 32 of the cover glass 4 is lifted, the glass overhanging portion 31 side of the cover glass 4 is lowered by the principle of leverage with the upper right corner portion 28 of the wall portion 20R as a fulcrum, and the flange portion 80 receives, from the cover glass 4, a force pushing downward (see an arrow B2), for example. Then, when the cover glass 4 tilts to a certain angle, the flange portion 80 breaks downward from the wall portion 20R.

Since the flange portion 80 has the fragile portion 95 in each rib portion 92, the flange portion 80 breaks at the base portion side (the wall portion 20R side) with the fragile portion 95 as a starting point, and the flange portion 80 including the flange main body portion 81 and the three rib portions 92 is entirely or almost entirely is separated from the wall portion 20R. Here, in order to separate the flange portion 80 from the wall portion 20R, a reciprocating operation of lifting and pressing the cover glass 4 is performed as needed.

As illustrated in Fig. 15B, when the flange portion 80 is separated from the wall portion 20R, the cover glass 4 is removed from the package main body portion 3 together with the flange portion 80 bonded to the glass overhanging portion 31 (see an arrow B3). That is, the component separated from the package main body portion 3 becomes an integrated separate body 99 including the flange portion 80 fixed, via the joint portion 48, to the right edge portion used to be the glass overhanging portion 31 in relation to the frame 6.

As a result, as illustrated in Fig. 15C, a solid-state imaging device 71A corresponding to the solid-state imaging device 71 from which the cover glass 4 has been removed is obtained. In the solid-state imaging device 71A, for example, on the outer wall surface 22 of the wall portion 20R, a mark 89 indicating the removal of the flange portion 80 exists as a fixation mark of the cover glass 4. The mark 89 is a separation portion of the resin member forming the frame 6, and becomes a portion slightly projecting from the outer wall surface 22 in a manner that depends on how the flange portion 80 breaks. Note that a point of breakage of the flange portion 80 caused by the lift of the cover glass 4 may be in the middle of the rib portion 92.

The solid-state imaging device 71 according to the present embodiment can produce the following effects the effects produced by the solid-state imaging device 1 according to the first embodiment. That is, the configuration where the flange portion 80 includes the flange main body portion 81 and the connecting portion 82 can make the flange portion 80 easy to break together with the cover glass 4. It is therefore possible to make the flange portion 80 easy to separate, and the cover glass 4 can be easily removed accordingly. In particular, the configuration where the connecting portion 82 includes the plurality of rib portions 92 can make the flange portion 80 easy to break.

Furthermore, in the flange portion 80, the flange main body portion 81 to which the glass overhanging portion 31 is fixed by the joint portion 48 is provided at a position spaced apart from the wall portion 20R. Such a configuration can prevent the adhesive forming the joint portion 48 from protruding from the fixed surface 83 toward the main body portion of the frame 6 and entering the glass support surface 23.

In particular, in the present embodiment, the adhesive forming the joint portion 48 is applied to an area where no rib portion 92 is formed in the extending direction of the flange main body portion 81. Such a configuration can set the region on the fixed surface 83 where the adhesive is applied apart from the rib portion 92 serving as a connection portion between the flange main body portion 81 and the wall portion 20R of the frame 6, so that it is possible to effectively prevent the adhesive from entering the glass support surface 23.

Furthermore, in a manner similar to the first embodiment, since the flange portion 80 has the fragile portion 95, the flange portion 80 can easily break at the area where the fragile portion 95 is formed. Furthermore, since the fixed surface 83 of the flange main body portion 81 of the flange portion 80 is lower in height position than the glass support surface 23 by the thickness of the joint portion 48, it is possible to support the cover glass 4 in a stable state relative to the frame 6 and prevent the entry of dust into the package.

### <7. Modification of solid-state imaging device according to second embodiment>

A modification of the solid-state imaging device 71 according to the second embodiment of the present technology will be described.

### (Configuration of modification)

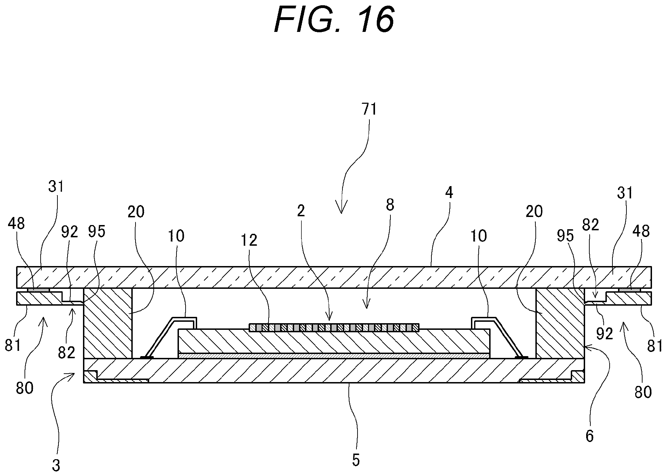

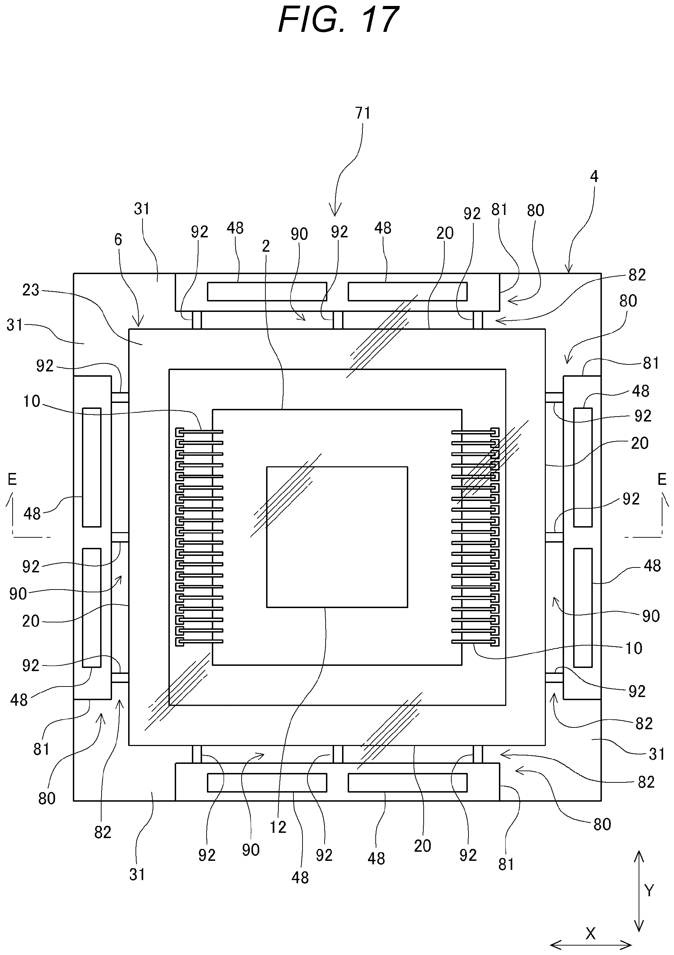

As illustrated in Figs. 16 and 17, according to this modification, in the solid-state imaging device 71 having a rectangular outline in plan view, a fixing portion (hereinafter, as "glass fixing portion") where the glass overhanging portion 31 is bonded and fixed to the flange portion 80 is provided on not only the right side but also the other three sides. That is, the glass fixing portion is provided along the four sides of the outline of the cover glass 4 in plan view. Note that Fig. 16 is a cross-sectional view taken along line E-E in Fig. 17.

As illustrated in Figs. 16 and 17, the cover glass 4 having a rectangular plate-shaped outline has both sides in the X direction and both sides in the Y direction projecting like an eave from the frame 6, and this projecting portion corresponds to the glass overhanging portion 31. That is, the cover glass 4 has an outline dimension slightly larger than the outline dimension of the frame 6 by the width of the glass overhanging portion 31, and has the glass overhanging portions 31 on all the four sides.

Furthermore, the frame 6 has a flange portion 80 to which the glass overhanging portion 31 is fixed provided on the outer sides of all the four wall portions 20. Then, the glass overhanging portions 31 of the cover glass 4 along the four sides are each fixed to the corresponding flange portion 80 by the joint portion 48 including an adhesive.

### (Method for removing cover glass 4 in configuration of modification)

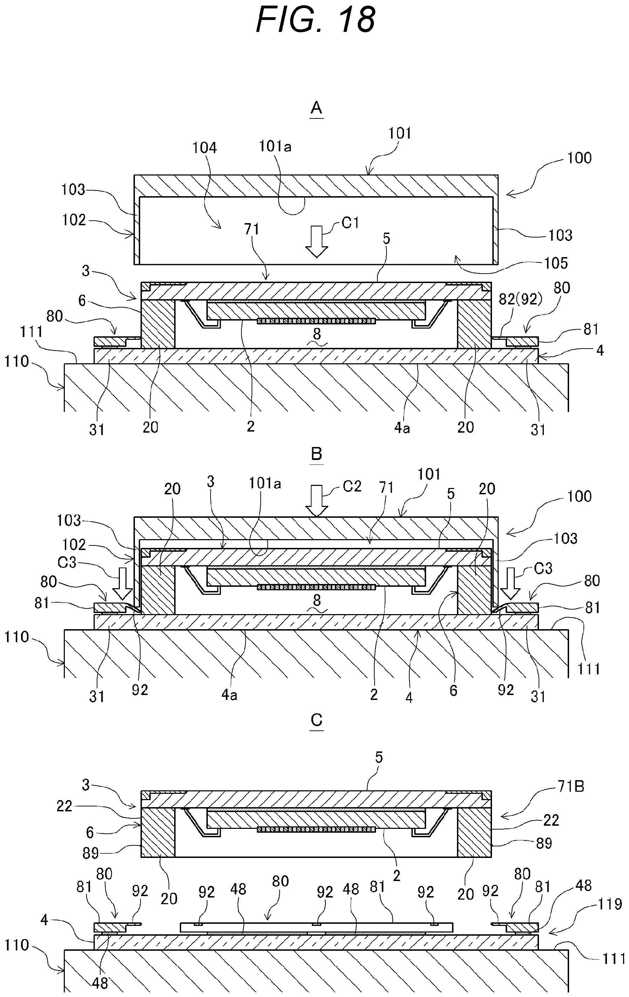

As illustrated in Fig. 18A, in the configuration of the modification of the solid-state imaging device 71, the cover glass 4 is removed using an extraction jig 100 for removing a cover glass and a support base 110.

The extraction jig 100 includes a base portion 101 and a pressing portion 102. The extraction jig 100 causes the pressing portion 102 to act on the flange portion 80 of the solid-state imaging device 71 to separate the cover glass 4 together with the flange portion 80 from the solid-state imaging device 71.

The base portion 101 is a rectangular plate-shaped portion. The pressing portion 102 is a peripheral wall-shaped portion provided on one plate surface 101a side of the base portion 101. The pressing portion 102 has extraction plate portions 103 provided on the four sides corresponding to the outline of the base portion 101, and the extraction plate portions 103 form a quadrangular tubular portion. The four extraction plate portions 103 of the pressing portion 102 form a quadrangular tubular space portion 104 that is open on the opposite side from the base portion 101, and edge portions on the open side of the four extraction plate portions 103 form a rectangular opening portion 105.

The pressing portion 102 is formed such that the extraction plate portions 103 correspond to the connecting portion 82 including the three rib portions 92 of the flange portions 80 provided on the four sides in a bottom view of the solid-state imaging device 71. That is, the pressing portion 102 is formed in a size that allows the extraction plate portions 103 to each coincide with the connecting portion 82 of the flange portions 80 provided on the four sides and located on the outer side of each wall portion 20 of the frame 6 in the bottom view of the solid-state imaging device 71.

Therefore, the opening portion 105 of the pressing portion 102 is formed to be slightly larger than the outline of the frame 6 that coincides with the outline of the substrate 5 in plan view. Preferably, the pressing portion 102 is formed such that the edge portions on the opening portion side of the four extraction plate portions 103 correspond to the area where the fragile portion 95 of the flange portion 80 is formed or the nearby area. Furthermore, the pressing portion 102 is formed so as to be larger in dimension in the height direction (the up-down direction in Fig. 18A) than the solid-state imaging device 71 in the up-down direction. As described above, the extraction jig 100 is configured to allow the package main body portion 3 of the solid-state imaging device 71 to fit into the space portion 104 of the pressing portion 102 from the substrate 5 side.

The support base 110 is a receiving jig that supports the solid-state imaging device 71 subjected to the action of the extraction jig 100, and has a horizontal support surface 111. On the support base 110, the solid-state imaging device 71 is set with the solid-state imaging device 71 turned upside down and supported on the support surface 111. That is, the solid-state imaging device 71 is set on the support base 110 so as to cause the upper surface 4a of the cover glass 4 to face the support surface 111 of the support base 110. In the example illustrated in Fig. 18A, the solid-state imaging device 71 is supported by the support base 110 with the upper surface 4a of the cover glass 4 as a surface that is in contact with the support surface 111. The support base 110 includes, for example, a clamp mechanism or the like for holding the solid-state imaging device 71 on the support surface 111, and sets the solid-state imaging device 71 in a fixed state.

The cover glass 4 is removed as follows by the extraction jig 100 and the support base 110 as described above.

First, as illustrated in Fig. 18A, the solid-state imaging device 71 is set on the support surface 111 with the cover glass 4 facing the support surface 111 of the support base 110. The solid-state imaging device 71 set on the support base 110 is in a state where the flange portions 80 provided on the four sides and located adjacent to the lower surface 4b of the cover glass 4 are exposed in top view (the bottom view of the solid-state imaging device 71).

As illustrated in Fig. 18A, with respect to the solid-state imaging device 71 set on the support base 110, the extraction jig 100 is moved down toward the solid-state imaging device 71 with the opening portion 105 facing the solid-state imaging device 71 so as to cause the package main body portion 3 to fit into the pressing portion 102 from the substrate 5 side (see an arrow C1). Note that the extraction jig 100 may be manually operated by an operator, or the extraction jig 100 may be automatically operated with the extraction jig 100 attached to a predetermined device including a lifting portion that moves up and down relative to the support base 110.

As illustrated in Fig. 18B, the extraction jig 100 moving toward the solid-state imaging device 71 on the support base 110 causes the package main body portion 3 to fit into the pressing portion 102 and cause the space portion 104 to receive almost the entirety of the package main body portion 3. That is, the extraction jig 100 covers the solid-state imaging device 71 turned upside down from above.

Then, the extraction jig 100 fitted to the package main body portion 3 is further moved down, and when the lower end portion of each of the extraction plate portions 103 of the pressing portion 102 reaches the rib portions 92 of the corresponding flange portion 80, the extraction jig 100 is pressed downward (see an arrow C2). As a result, as illustrated in Fig. 18B, the three rib portions 92 of each flange portion 80 are broken by the pressing action from the extraction plate portions 103 (see an arrow C3). That is, the three rib portions 92 of each of the flange portions 80 provided on the four sides are simultaneously broken. Here, since each rib portion 92 has the fragile portion 95, the rib portion 92 breaks at the base portion side (the wall portion 20 side) with the fragile portion 95 as a starting point, and the flange portion 80 is entirely or almost entirely separated from the wall portion 20.

As an example of the operation mode of the extraction jig 100, the extraction jig 100 is pressed downward until the lower edge portion of each of the extraction plate portions 103 that has broken the rib portions 92 comes into contact with the lower surface 4b of the cover glass 4. The extraction jig 100 is removed from the solid-state imaging device 71 after the rib portions 92 have been broken.

As illustrated in Fig. 18C, the flange portions 80 are separated from the wall portions 20 provided on the four sides of the frame 6, so that the cover glass 4 is removed from the package main body portion 3 together with the flange portions 80 bonded to the respective glass overhanging portions 31 on the four sides. That is, the component separated from the package main body portion 3 becomes an integrated separate body 119 including the flange portions 80 fixed, via the joint portion 48, to the four edge portions of the cover glass 4 used to be the glass overhanging portions 31 in relation to the frame 6.

As a result, as illustrated in Fig. 18C, a solid-state imaging device 71B corresponding to the solid-state imaging device 71 from which the cover glass 4 has been removed is obtained. In the solid-state imaging device 71B, for example, on the outer wall surface 22 of each wall portion 20, there is a mark 89 indicating the removal of the flange portion 80.

### (Another example of method for removing cover glass 4 in configuration of modification)

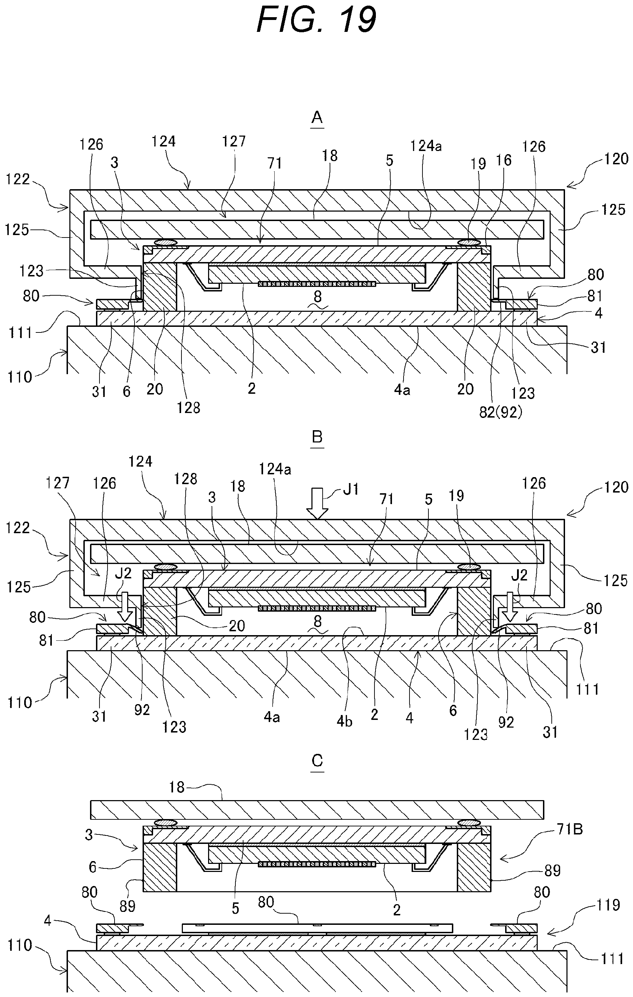

As illustrated in Fig. 19A, this example is an example of a case where the cover glass 4 is removed after the solid-state imaging device 71 is installed by reflow soldering, that is, in a state where the solid-state imaging device 71 is installed by reflow soldering on the set board 18 in the configuration of the modification of the solid-state imaging device 71. In this case, in order to remove the cover glass 4, an extraction jig 120 different from the extraction jig 100 described above is used as a jig for removing a cover glass. Note that the solid-state imaging device 71 is electrically connected to the set board 18 by the solder balls 19 provided for the terminal electrodes 16 of the substrate 5.

The extraction jig 120 has a base portion 122 and a pair of pressing portions 123. The extraction jig 120 causes the pressing portions 123 to act on the flange portion 80 of the solid-state imaging device 71 to separate the cover glass 4 from the solid-state imaging device 71 together with the flange portion 80. The extraction jig 120 breaks the rib portions 92 of the flange portions 80 provided on two opposite sides in response to a single operation. Therefore, the extraction jig 120 breaks the rib portions 92 of the flange portions 80 on the four sides in response to two operations each performed on two opposite sides.

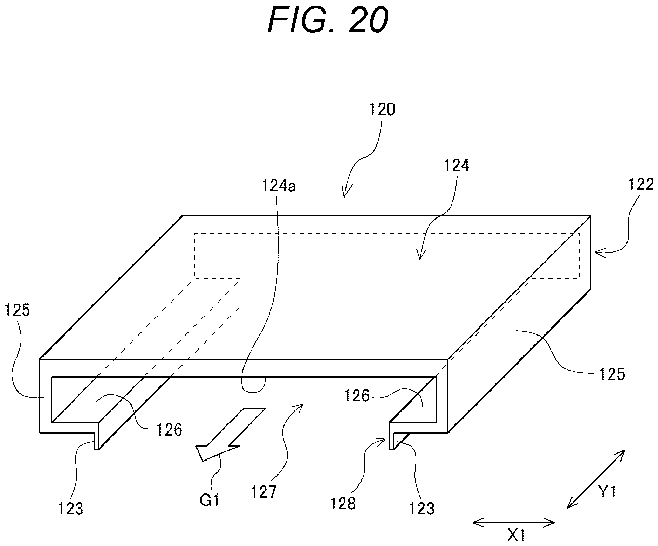

The base portion 122 is a flat tubular portion having both end sides open and a lower side open. Note that the extraction jig 120 is formed as a whole so as to have a uniform cross-sectional shape in a direction (Y1 direction illustrated in Fig. 20) in which both end sides are open, and has a through portion extending in the Y1 direction. Furthermore, the extraction jig 120 is symmetrical with respect to an X1 direction orthogonal to the Y1 direction in plan view (see Fig. 20).

The base portion 122 includes a horizontal upper plate portion 124 having a rectangular plate-shaped outline in plan view, a pair of side plate portions 125 formed extending downward from both edge portions of the upper plate portion 124 in the X1 direction, and a horizontal lower plate portion 126 formed extending inward in the X1 direction from a lower edge portion of each of the side plate portions 125. In the illustrated example, the upper plate portion 124, the side plate portions 125, and the lower plate portions 126 are each a plate-shaped portion having a predetermined thickness.

The upper plate portion 124 is larger in outline dimension than the set board 18 in plan view, and a distance between the pair of side plate portions 125 facing each other is larger than a dimension in the longitudinal direction of the outline of the rectangular plate-shaped set board 18 in plan view. A distance in the X1 direction between the pair of lower plate portions 126 is almost equal to (slightly larger than) the dimensions in the X direction and the Y direction of the frame 6 in the solid-state imaging device 71. Of the base portion 122, the upper plate portion 124, the pair of side plate portions 125, and the pair of lower plate portions 126 form a space portion 127 having both sides in the Y1 direction open and a lower side open. The space portion 127 is a clearance for a part of the set board 18 and the package main body portion 3.

The pressing portions 123 are each a plate-shaped portion formed at a right angle to and extending downward from an inner edge portion of the corresponding lower plate portion 126 of the base portion 122. The pair of pressing portions 123 are plate portions parallel to each other, and face each other in the X1 direction. Lower edge portions of the pair of pressing portions 123 form an opening portion 128 on the lower side of the extraction jig 120.

The extraction jig 120 is formed such that the pair of pressing portions 123 correspond to the connecting portion 82 including the three rib portions 92 of the flange portions 80 on two opposite sides in the bottom view of the solid-state imaging device 71. That is, the pair of pressing portions 123 are formed at positions that coincide with the connecting portion 82 of the flange portions 80 located on the outer sides the wall portions 20 on two opposite sides of the frame 6 in the bottom view of the solid-state imaging device 71.

Therefore, the opening portion 128 formed by the pair of pressing portions 123 has an opening dimension slightly larger than the dimensions in the X direction and the Y direction of the frame 6 whose outline coincides with the substrate 5 in plan view. Preferably, the pair of pressing portions 123 are formed such that their respective lower edge portions correspond to the area where the fragile portions 95 of the flange portions 80 on two opposite sides are formed or the nearby area.

Furthermore, the extraction jig 120 is formed such that a dimension in the up-down direction between a lower surface 124a of the upper plate portion 124 to a lower end of the pressing portion 123 is larger than a dimension in the up-down direction of the configuration where the solid-state imaging device 71 is installed on the set board 18. As described above, the extraction jig 120 is configured to allow the configuration where the solid-state imaging device 71 is installed on the set board 18 to be entirely positioned in the space portion 127 of the base portion 122 and the opening portion 128 formed by the pair of pressing portions 123, the opening portion 128 communicating with the space portion 127.

The cover glass 4 is removed as follows by the extraction jig 120 and the support base 110 as described above.

First, as illustrated in Fig. 19A, the solid-state imaging device 71 in an installed-on-board state where the solid-state imaging device 71 is installed on the set board 18 is set on the support surface 111 of the support base 110 with the cover glass 4 facing the support surface 111. In the solid-state imaging device 71 in the installed-on-board state, that is, in the solid-state imaging device 71 set on the support base 110, the flange portions 80 provided on the four sides and located adjacent to the lower surface 4b of the cover glass 4 are covered by the set board 18 in top view (the bottom view of the solid-state imaging device 71).

As illustrated in Fig. 19A, the extraction jig 120 is slid toward the solid-state imaging device 71 in the installed-on-board state, that is, the solid-state imaging device 71 set on the support base 110 in the lateral direction to position the set board 18 and the portion of the solid-state imaging device 71 adjacent to the substrate 5 in the space portion 127. Here, the extraction jig 120 is moved parallel to the through direction (Y1 direction) of the jig shape (see, for example, an arrow G1 in Fig. 20) to receive the solid-state imaging device 71 and the set board 18 from one opening portion in the through direction. Note that the extraction jig 120 may be manually operated by an operator, or the extraction jig 120 may be automatically operated with the extraction jig 120 attached to a predetermined device including a moving portion that horizontally moves and moves up and down relative to the support base 110.

As illustrated in Fig. 19A, in a state where the extraction jig 120 is set to the solid-state imaging device 71 in the installed-on-board state, the set board 18 is entirely received in the space portion 127, the package main body portion 3 is fitted between the pair of pressing portions 123, and the pair of pressing portions 123 are positioned on the flange portions 80 provided on two opposite sides.

Then, as illustrated in Fig. 19B, the extraction jig 120 set to the solid-state imaging device 71 in the installed-on-board state is moved down, and when the lower end portions of the pair of pressing portions 123 each come into contact with the rib portions 92 of the corresponding flange portion 80, the extraction jig 120 is pressed downward (see an arrow J1). As a result, the three rib portions 92 of each flange portion 80 are broken by the pressing action from the pressing portions 123 (see an arrow J2). That is, the three rib portions 92 of each flange portion 80 provided on two opposite sides are simultaneously broken. Here, since each rib portion 92 has the fragile portion 95, the rib portion 92 breaks at the base portion side (the wall portion 20 side) with the fragile portion 95 as a starting point, and the flange portion 80 is entirely or almost entirely separated from the wall portion 20.

As an example of the operation mode of the extraction jig 120, the extraction jig 120 is pressed downward until the lower edge portion of each of the pressing portions 123 that has broken the rib portions 92 comes into contact with the lower surface 4b of the cover glass 4. After breaking the rib portions 92, the extraction jig 120 is removed from the solid-state imaging device 71 in the installed-on-board state by lateral movement in the through direction.

In order to break the flange portions 80 provided on the remaining two opposite sides, the extraction jig 120 removed from the solid-state imaging device 71 in the installed-on-board state is set to the solid-state imaging device 71 in the installed-on-board state by lateral movement in the through direction with the extraction jig 120 rotated 90° with the up-down direction as the axial direction relative to the solid-state imaging device 71. Thereafter, the rib portions 92 of the flange portions 80 provided on the remaining two sides are broken by the extraction jig 120 in a manner similar to the flange portions 80 provided on the first two sides. After the breaking of the rib portions 92, the extraction jig 120 is removed from the solid-state imaging device 71 in the installed-on-board state by lateral movement in the through direction.

As described above, the flange portions 80 are separated from the wall portions 20 on all the four sides of the frame 6, so that the cover glass 4 is removed as the separate body 119 from the package main body portion 3 together with the flange portions 80 bonded to the glass overhanging portions 31 provided on the four sides as illustrated in Fig. 19C. As a result, a configuration where the cover glass 4 is removed from the solid-state imaging device 71 in the installed-on-board state, that is, a configuration where the solid-state imaging device 71B is installed on the set board 18 is obtained.

As in the configuration of this modification, providing the glass fixing portions on the four sides of the cover glass 4 allows an increase in adhesive strength between the cover glass 4 and the package main body portion 3. It is therefore possible to prevent the cover glass 4 from being unintentionally separated during transportation of the solid-state imaging device 71 or the like.

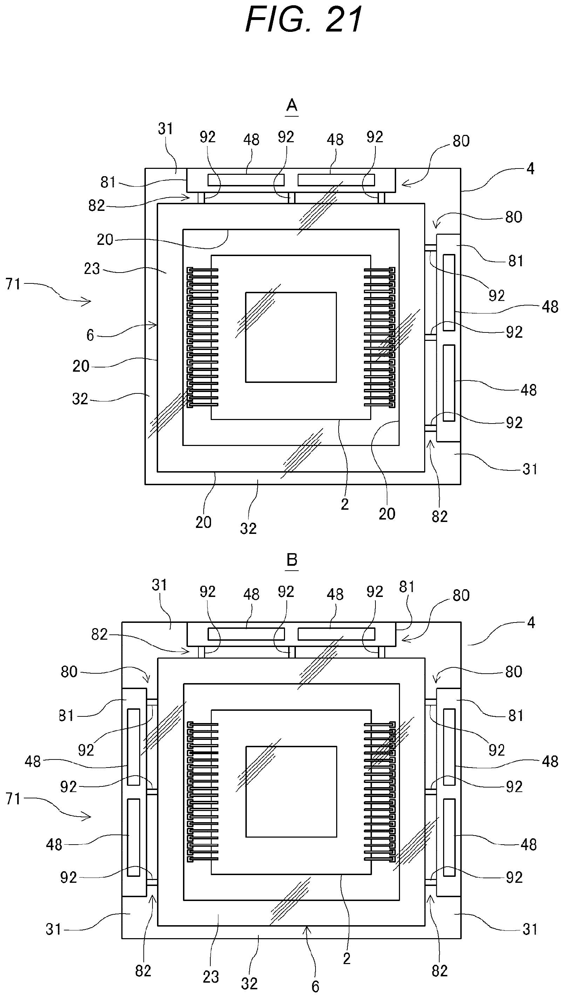

As described above, the glass overhanging portion 31 forming the glass fixing portion may be provided as a portion along a plurality of sides of the outline of the glass support surface 23 of the frame 6 in plan view. Therefore, for example, the glass fixing portions may be provided on two adjacent sides of the rectangular outline of the glass support surface 23 in plan view as illustrated in Fig. 21A, or may be provided on three sides of the rectangular outline of the glass support surface 23 in plan view as illustrated in Fig. 21B.

In the configuration illustrated in Fig. 21A, the opposite-side overhanging portion 32 is provided at an edge portion on the opposite side of the cover glass 4 from each glass fixing portion. Furthermore, in the configuration illustrated in Fig. 21B, the opposite-side overhanging portion 32 is provided at an edge portion on a side of the cover glass 4 where no glass fixing portion is provided. Note that the configuration where the glass fixing portions are provided on two sides is not limited to the configuration where the glass fixing portions are provided on two adjacent sides as illustrated in Fig. 21A, and may be a configuration where the glass fixing portions are provided on two opposite sides.

Furthermore, regarding the removal of the cover glass 4, it is possible to cut, with the extraction jig 100 and 120, and the support base 110 as illustrated in Figs. 18A and 20, the flange portions 80 provided on a plurality of sides simultaneously in response to a simple operation, that is, an operation of pressing the extraction jig 100 and 120. As a result, the plurality of flange portions 80 can be separated from the frame 6 all at once, so that the cover glass 4 can be easily removed as compared to a case where the flange portions 80 are cut one by one or the rib portions 92 are cut one by one using a tool or the like, for example.

As illustrated in Figs. 21A and 21B, the extraction jig 100 and 120, and the support base 110 can also be used for the configuration where the glass fixing portions are provided on two or three sides of the cover glass 4 in a manner similar to the configuration where the glass fixing portions are provided on the four sides of the cover glass 4. That is, in the configuration where the glass fixing portions are provided on two or more sides, the cover glass 4 can be easily removed by using the extraction jig 100 and 120, and the support base 110.

Note that, in the configuration where the glass fixing portions are provided on two adjacent sides as illustrated in Fig. 21A, for example, lifting the cover glass 4 with at least one of the adjacent opposite-side overhanging portions 32 as a holding portion allows the cover glass 4 to be removed together with the two flange portions 80 without using the jig. In this case, for example, lifting the corner portion 33 formed by the two adjacent opposite-side overhanging portions 32 in the diagonal direction as a holding portion separates the cover glass 4 from the package main body portion 3 together with the two flange portions 80.

### <8. Configuration example of solid-state imaging device according to third embodiment>

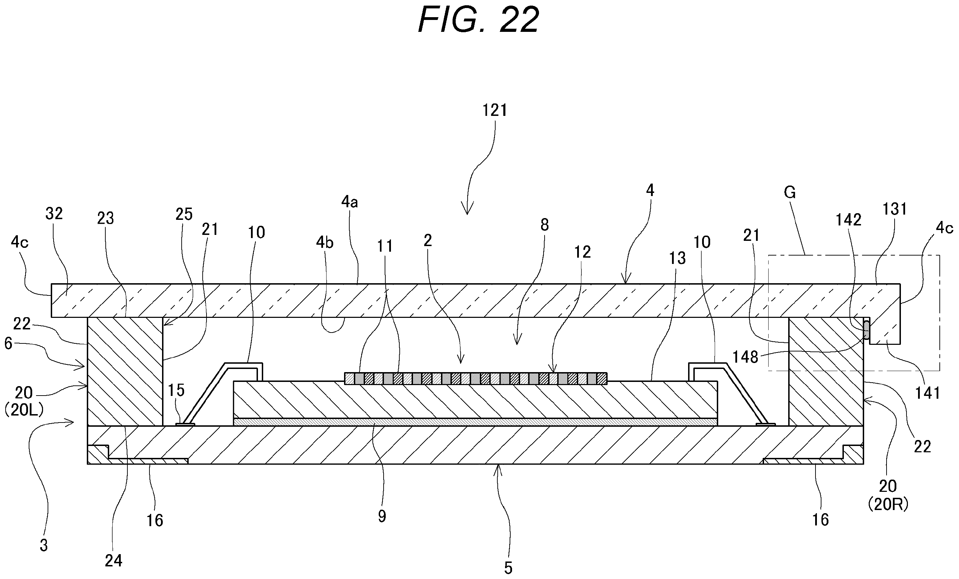

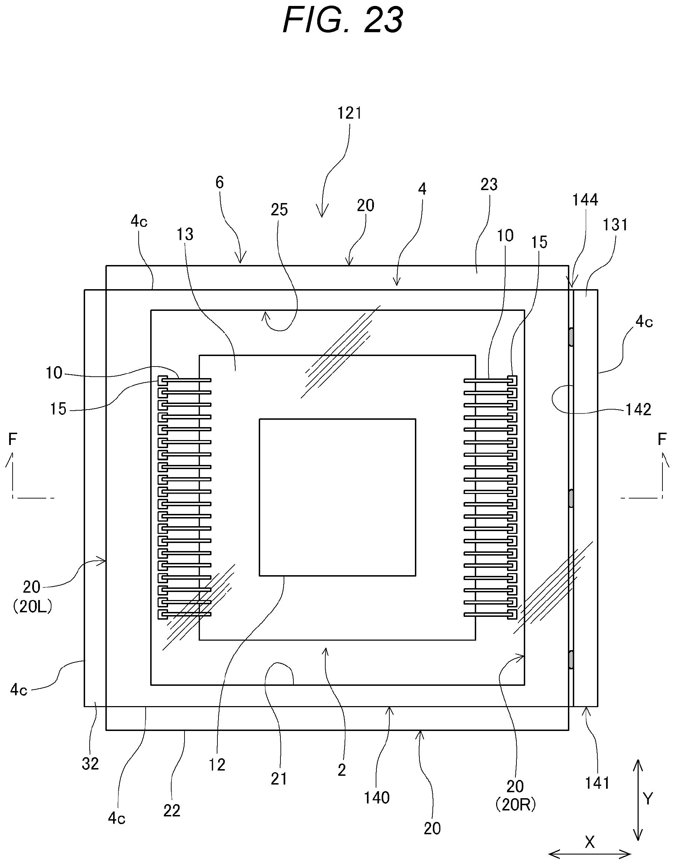

A configuration example of a solid-state imaging device 121 according to a third embodiment of the present technology will be described with reference to Figs. 22 to 26. Note that Fig. 22 is a cross-sectional view taken along line F-F in Fig. 23.

In the solid-state imaging device 121 according to the present embodiment, the cover glass 4 has a glass overhanging portion 131 that sticks out over the outline of the glass support surface 23 of the frame 6 in plan view, and is provided with the glass overhanging portion 131 fixed to the frame 6.

The dimension in the longitudinal direction (the left-right direction in Fig. 23) of the rectangular plate-shaped outline of the cover glass 4 is larger than the dimension of the frame 6 in the same direction. The cover glass 4 has one side (right side in Fig. 23) in the longitudinal direction projecting like an eave from the frame 6, and this projecting portion corresponds to the glass overhanging portion 131. A right-edge portion of the cover glass 4 having a uniform width corresponds to the glass overhanging portion 131 for the frame 6.

As described above, in the solid-state imaging device 121, the glass overhanging portion 131 is provided as a portion along one side (right side) of the rectangular shape that is the outline of the glass support surface 23 of the frame 6 in plan view. The glass overhanging portion 131 of the cover glass 4 corresponds to a fixing portion fixed to the frame 6.

The glass overhanging portion 131 of the cover glass 4 has a fixing surface forming portion 141 that forms a fixing surface 142 facing the outer wall surface 22 that is an outer side surface of the right wall portion 20R of the frame 6. The fixing surface forming portion 141 is formed as a part of a glass body as the cover glass 4. That is, the cover glass 4 includes a glass main body portion 140 that is a flat plate-shaped portion and forms the lower surface 4b, and the fixing surface forming portion 141 formed along a right edge portion of the glass main body portion 140.

The fixing surface forming portion 141 is a protruding portion provided at an edge portion of the cover glass 4 and protruding downward relative to the lower surface 4b supported by the glass support surface 23 of the frame 6. The fixing surface forming portion 141 is formed such that the cover glass 4 has a uniform cross-sectional shape throughout the Y direction. The fixing surface forming portion 141 is formed to have a rectangular cross-sectional shape in side view, and the dimension in the up-down direction of the right side surface 4c of the cover glass 4 increases downward.

The fixing surface forming portion 141 has, as a lower surface, a step surface 143 located below the lower surface 4b. A surface on the opposite side (left side) of the fixing surface forming portion 141 from the right side surface 4c, that is, an inner surface corresponds to the fixing surface 142. The fixing surface 142 is a surface along the up-down direction, and faces the outer wall surface 22 of the wall portion 20R in parallel with a predetermined gap 144 provided between the fixing surface 142 and the outer wall surface 22.

The step surface 143 and the right side surface 4c of the fixing surface forming portion 141 form a right-angled outer corner portion 146. Furthermore, the step surface 143 and the fixing surface 142 of the fixing surface forming portion 141 form a right-angled inner corner portion 147.

As described above, the cover glass 4 has the fixing surface forming portion 141, so that a step portion forming the fixing surface 142 is formed at the edge portion on one side (right side). In the present embodiment, the fixing surface forming portion 141 is provided so as to form an approximately "L" shape together with the glass main body portion 140 in a side view of the cover glass 4, but the fixing surface forming portion 141 may be any step portion as long as the step portion forms the fixing surface 142 for the glass main body portion 140.

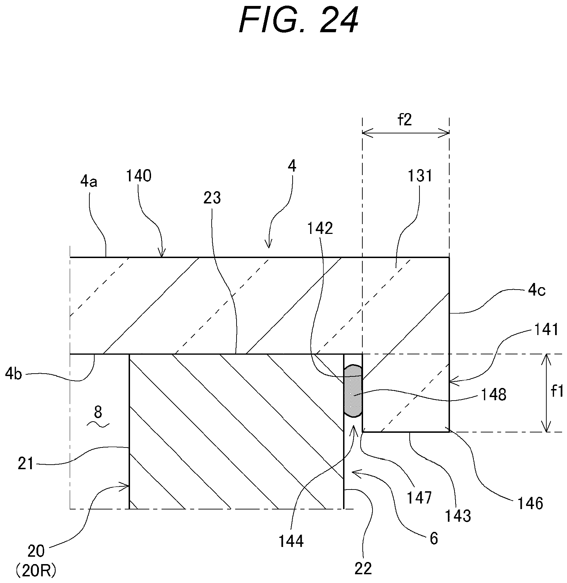

In the example illustrated in Fig. 24, a projection dimension f1 of the fixing surface forming portion 141 relative to the lower surface 4b of the cover glass 4 is almost the same as the thickness dimension of the glass main body portion 140. Furthermore, the projection dimension f1 is about 1/4 of the dimension of the entirety of the frame 6 in the up-down direction. The size of the projection dimension f1 of the fixing surface forming portion 141 is not particularly limited, but the projection dimension f1 is, for example, a dimension smaller than half of the dimension of the frame 6 in the up-down direction. Note that the projection dimension f1 is a dimension in the up-down direction between the lower surface 4b and the step surface 143.

Furthermore, in the example illustrated in Fig. 24, a thickness dimension f2 of the fixing surface forming portion 141 is almost the same as the thickness dimension of the glass main body portion 140. Note that the thickness dimension f2 is a dimension in the left-right direction between the right side surface 4c and the fixing surface 142.

As described above, of the cover glass 4 having the fixing surface forming portion 141, the fixing surface forming portion 141 is fixed to the frame 6 with an adhesive. That is, the cover glass 4 is fixed to the frame 6 by a joint portion 148 including the adhesive with the fixing surface 142 of the fixing surface forming portion 141 as a surface bonded to the outer wall surface 22 of the wall portion 20R.

The joint portion 148 is interposed between the upper end portion of the outer wall surface 22 of the wall portion 20R and the fixing surface 142 of the fixing surface forming portion 141. The adhesive forming the joint portion 148 includes, for example, a thermosetting resin or a photocurable resin such as an ultraviolet (UV) curable resin.

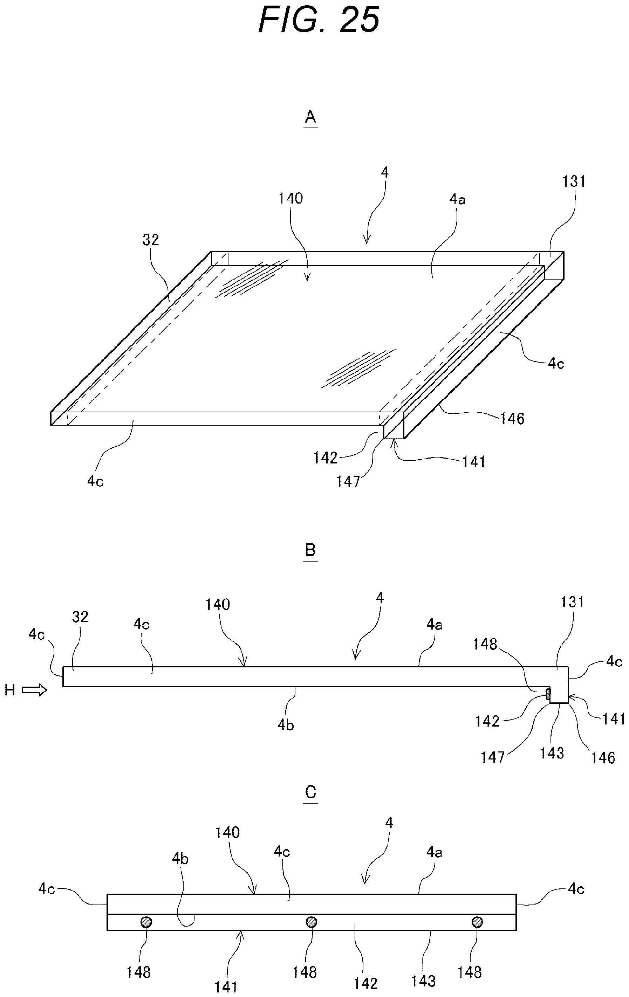

As illustrated in Fig. 25C, the adhesive is applied to the fixing surface 142 of the fixing surface forming portion 141 at three points: a center portion and portions near both end portions in the Y direction (left-right direction in Fig. 25C), in a dot shape or a circular shape to form the joint portion 148. Note that the mode of applying the adhesive to the fixing surface 142, that is, the mode of forming the joint portion 148 is not particularly limited. As the mode of applying the adhesive to the fixing surface 142, for example, the adhesive may be linearly applied in a continuous or discontinuous pattern along the Y direction or may be applied in a plurality of parallel line patterns along the Y direction. Furthermore, the application amount and the application area of the adhesive are set in accordance with the size and the like of the cover glass 4 so as to ensure retention force (adhesive force) required for the cover glass 4 and to make the cover glass 4 easy to separate when the cover glass 4 is removed.

The cover glass 4 is fixed to the outer wall surface 22 of the wall portion 20R of the frame 6 with the adhesive, and is placed and supported on the glass support surface 23 of the main body portion of the frame 6 in a non-adhered condition. That is, the fixing surface 142 of the fixing surface forming portion 141 of the cover glass 4 is bonded and fixed to the outer wall surface 22 of the wall portion 20R, and the lower surface 4b of the cover glass 4 is a non-fixed contact surface that is in contact with the glass support surface 23 with no adhesive applied.

Furthermore, in a manner similar to the first embodiment, the cover glass 4 has the opposite-side overhanging portion 32 that sticks out over the outline of the glass support surface 23 of the frame 6 in plan view provided on the opposite side from the glass overhanging portion 131.

### <9. Method for manufacturing solid-state imaging device according to third embodiment>

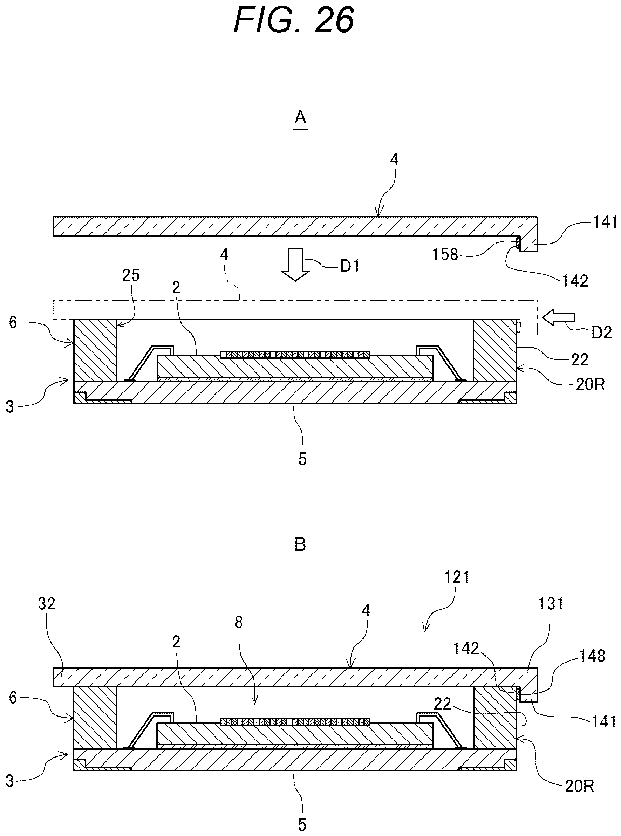

An example of a method for manufacturing the solid-state imaging device 121 according to the third embodiment of the present technology will be described with reference to Fig. 26.

As illustrated in Fig. 26A, a configuration where the image sensor 2 is installed on the substrate 5, and the frame 6 is provided on the substrate 5 is manufactured by a method similar to the manufacturing method according to the first embodiment. On such a configuration, a process of providing the cover glass 4 on the frame 6 is performed. For example, a glass plate having a predetermined shape is subjected to cutting processing with a predetermined tool such as a dicing blade, processing using etching, and the like to form and prepare the cover glass 4 having the fixing surface forming portion 141.

In the process of providing the cover glass 4, as illustrated in Fig. 26A, an adhesive 158 to be the joint portion 148 is applied to the fixing surface 142 of the fixing surface forming portion 141 of the cover glass 4. The adhesive 158 is applied in a predetermined amount and manner so as to ensure adhesive force required for the cover glass 4.

After the application of the adhesive 158, the cover glass 4 is placed on the glass support surface 23 by a chip mounter or the like so as to close the opening portion 25 of the frame 6 from above (see an arrow D1). In order to bond the fixing surface forming portion 141 to the wall portion 20R of the frame 6, for example, a pressing force in the lateral direction (see an arrow D2) from right to left is applied to the cover glass 4 placed on the glass support surface 23 so as to press the fixing surface forming portion 141 against the wall portion 20R.

The adhesive 158 includes, for example, a thermosetting resin or a photocurable resin such as an ultraviolet (UV) curable resin. The adhesive 158 is applied to three points on the fixing surface 142, for example, as with the joint portion 148 illustrated in Fig. 25C. Note that the adhesive 158 may be applied to the outer wall surface 22 of the frame 6.

After the cover glass 4 is placed on the frame 6, a process of curing the adhesive 158 is performed in accordance with the material of the adhesive 158 and the like, in a manner similar to the adhesive 58 according to the first embodiment. When the adhesive 158 is cured, the cover glass 4 is supported on the frame 6 with the fixing surface forming portion 141 fixed to the wall portion 20R of the frame 6 by the joint portion 148.

As a result of the manufacturing processes described above, the solid-state imaging device 121 as illustrated in Figs. 22 and 23 is obtained.

### <10. Use example of solid-state imaging device according to third embodiment>

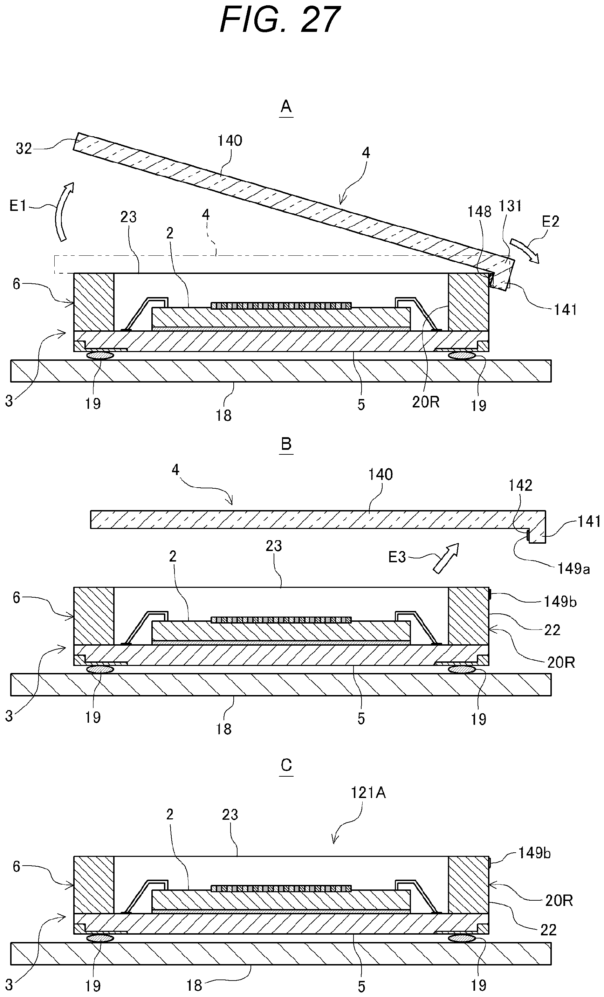

As a use example of the solid-state imaging device 121 according to the third embodiment of the present technology, how to remove the cover glass 4 will be described with reference to Fig. 27. In the solid-state imaging device 121, the cover glass 4 is removed in a manner similar to the first embodiment.

In order to remove the cover glass 4, from the state illustrated in Fig. 22, the opposite-side overhanging portion 32 serves as a holding portion, and the opposite-side overhanging portion 32 of the cover glass 4 is lifted to tilt the cover glass 4 as illustrated in Fig. 27A (see an arrow E1), so that the bonding portion of the fixing surface forming portion 141 bonded to the main body portion of the frame 6 by the joint portion 148 is taken off.

Regarding the lift of the cover glass 4 with the opposite-side overhanging portion 32 as a holding portion, the cover glass 4 causes the fixing surface forming portion 141 inseparable from the glass main body portion 140 to tilt. Note that since the cover glass 4 is not bonded to the glass support surface 23, the cover glass 4 is lifted without resistance to the main body portion of the frame 6.

When the opposite-side overhanging portion 32 of the cover glass 4 is lifted, the fixing surface forming portion 141 receives a force from above in a direction away from the wall portion 20R by the principle of leverage (see an arrow E2). Then, when the cover glass 4 tilts to a certain angle, the bonding portion of the fixing surface forming portion 141 by the joint portion 148 is taken off from the wall portion 20R.

As illustrated in Fig. 27B, when the fixing surface forming portion 141 is separated from the wall portion 20R, the cover glass 4 is removed from the package main body portion 3 (see an arrow E3). The cover glass 4 thus removed may have an adhesive 149a that is a part of the joint portion 148 left on the fixing surface 142.

As a result, as illustrated in Fig. 27C, a solid-state imaging device 121A corresponding to the solid-state imaging device 121 from which the cover glass 4 has been removed is obtained. In the solid-state imaging device 121A, for example, on the outer wall surface 22 of the wall portion 20R, an adhesive 149b that is a part of the joint portion 148 may exist as a fixation mark of the cover glass 4.

According to one aspect of the method for using the solid-state imaging device 121 as described above, the following method is used as a method for manufacturing an electronic device. That is, the method for manufacturing an electronic device includes a process of removing the cover glass 4 from the frame 6 of the package main body portion 3 by lifting the cover glass 4, and a process of attaching the solid-state imaging device 121A from which the cover glass 4 has been removed to a predetermined attachment area of the electronic device.

In the solid-state imaging device 121 according to the present embodiment as described above, since the cover glass 4 is bonded and fixed to the side surface of the frame 6, the glass support surface 23 can be kept clean without leaving, with the cover glass 4 removed from the package main body portion 3, the adhesive on the glass support surface 23, and the cover glass 4 can be easily removed, in a manner similar to the solid-state imaging device 1 according to the first embodiment.

The solid-state imaging device 121 of the present embodiment eliminates the need of providing the flange portion on the frame 6 side, so that the configuration of the frame 6 can be simplified as compared to the configuration of the first embodiment and the like. It is therefore possible to use an existing configuration for the frame 6.

Furthermore, it is possible to recycle the cover glass 4 removed from the package main body portion 3 by cleaning the cover glass 4 to remove the adhesive 149a and the like.

### <11. Modification of solid-state imaging device according to third embodiment>

A modification of the solid-state imaging device 121 according to the third embodiment of the present technology will be described.

### (First modification)

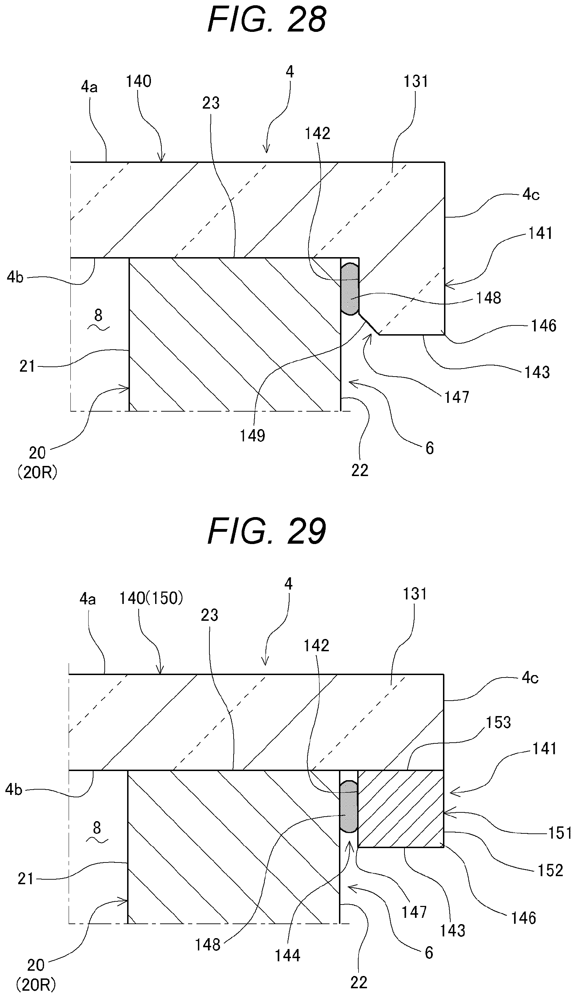

A first modification of the solid-state imaging device 121 according to the third embodiment will be described with reference to Fig. 28. The step surface 143 of the fixing surface forming portion 141 of the cover glass 4 is a lower end surface that is lower in position than the lower surface 4b of the cover glass 4 that is a supported surface supported by the glass support surface 23 and forms the inner corner portion 147 together with the fixing surface 142.

Then, as illustrated in Fig. 28, in a configuration of the first modification, the inner corner portion 147 has a chamfered shape. The inner corner portion 147 forms a chamfered portion having an inclined surface 149 formed between the fixing surface 142 and the step surface 143. The inclined surface 149 is formed over the fixing surface forming portion 141 in the Y direction.

The inclined surface 149 has an inclination angle of, for example, 45°. The inclined surface 149 is formed, for example, in a range of about 1/4 to 1/3 of the dimension in the up-down direction of the fixing surface forming portion 141 (see the projection dimension f1 in Fig. 24).

The configuration where the fixing surface forming portion 141 has the chamfered shape at the inner corner portion 147 as in the configuration of the first modification can prevent the inner corner portion 147 of the fixing surface forming portion 141 from coming into contact with the outer wall surface 22 of the frame 6 when the cover glass 4 is lifted to be removed from the package main body portion 3. It is therefore possible to make the handling of the cover glass 4 easy when the operation of lifting the cover glass 4 is performed and to prevent chipping, breakage, or the like of the cover glass 4.

### (Second modification)

A second modification of the solid-state imaging device 121 according to the third embodiment will be described with reference to Fig. 29. As illustrated in Fig. 29, in a configuration of the second modification, the fixing surface forming portion 141 includes an attachment body 151 that is a member separate from a member forming the glass main body portion 140.

That is, for the cover glass 4, a rectangular plate-shaped glass plate 150 having an upper surface 4a and a lower surface 4b is used as the member forming the glass main body portion 140, and the attachment body 151 is fixed to an edge portion on one side of the glass plate 150 to form the fixing surface forming portion 141. The attachment body 151 is a quadrangular prism member having a rectangular cross-sectional shape, and has a length equal to the dimension of the cover glass 4 in the Y direction.

An upper surface 153 of the attachment body 151 is fixed to the lower surface 4b of the glass plate 150 forming the glass main body portion 140 with an adhesive or the like to form the fixing surface forming portion 141. The attachment body 151 has an outer side surface 152 forming a flush side surface 4c together with a right side surface of the glass plate 150 forming the glass main body portion 140, and a surface on the opposite side from the outer side surface 152 as a fixing surface 142 of the fixing surface forming portion 141. The attachment body 151 has a lower surface on the opposite side from the upper surface 153 as a step surface 143 of the fixing surface forming portion 141.

A material of the attachment body 151 is not particularly limited. Examples of the material of the attachment body 151 include a resin material such as an epoxy resin, a metal material such as stainless steel or copper (Cu), ceramics, glass, and the like.

As in the configuration of the second modification, the attachment body 151 attached to the glass plate 150 may form the fixing surface forming portion 141 provided on the glass overhanging portion 131 of the cover glass 4. In such a configuration, since the flat glass plate 150 can be used as the member forming the glass main body portion 140, an existing cover glass can be used, and the fixing surface forming portion 141 serving as a portion fixed to the frame 6 can be easily provided.

### (Third modification)

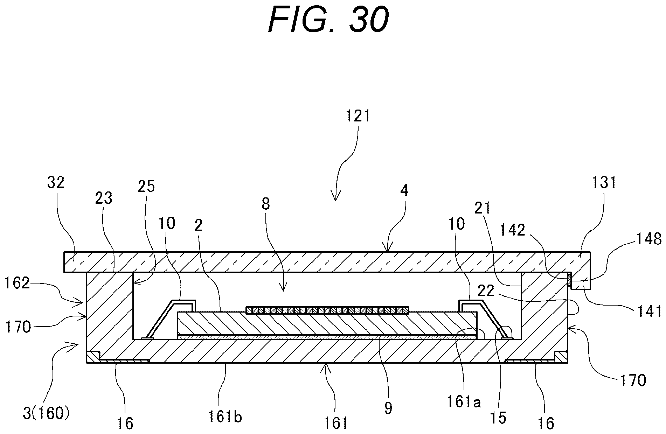

A third modification of the solid-state imaging device 121 according to the third embodiment will be described with reference to Fig. 30. As illustrated in Fig. 30, in a configuration of the third modification, the package main body portion 3 includes an integrated cavity substrate 160. That is, each portion of the cavity substrate 160 forms a portion corresponding to each of the substrate 5 and the frame 6.

The cavity substrate 160 is a package substrate forming a box-shaped package main body portion 3 with an upper side as an open side. The cavity substrate 160 includes a substrate portion 161 on which the image sensor 2 is installed, and a frame portion 162 that is provided on the upper side of the substrate portion 161 so as to surround the image sensor 2 and has an opening portion 25 formed on the upper side.

The substrate portion 161 is a rectangular plate-shaped flat portion and is a portion corresponding to the substrate 5 having the configuration illustrated in Fig. 22. The substrate portion 161 has a front surface 161a on which the image sensor 2 is installed and a back surface 161b on the opposite side from the front surface 161a. The image sensor 2 is bonded onto the front surface 161a by a die bonding material 9. The substrate portion 161 and the image sensor 2 are electrically connected by a plurality of wires 10 each having one end connected to an electrode 15 formed on the front surface 161a. A plurality of terminal electrodes 16 is formed on the back surface 161b side.

The frame portion 162 is a frame-shaped portion and is a portion corresponding to the frame 6 having the configuration illustrated in Fig. 22. The frame portion 162 includes wall portions 170 provided on the four sides that form the glass support surface 23 in a rectangular frame shape in plan view. The wall portion 170 is a portion similar in outline to the wall portion 20 of the frame 6, and has an inner wall surface 21 and an outer wall surface 22. Furthermore, the frame portion 162 has the rectangular opening portion 25 on the upper side.

The cavity substrate 160 is a circuit board on which a predetermined circuit is formed, and is a multilayered ceramic substrate including layers of ceramic sheet members or the like. Note that the cavity substrate 160 may be another type of substrate such as an organic substrate.

As in the third modification, the package main body portion according to the present technology may include an integrated member like the cavity substrate 160. Adopting such a configuration eliminates the need of the frame 6 and can simplify the package structure and the package manufacturing process.

### <12. Configuration example of solid-state imaging device according to fourth embodiment>

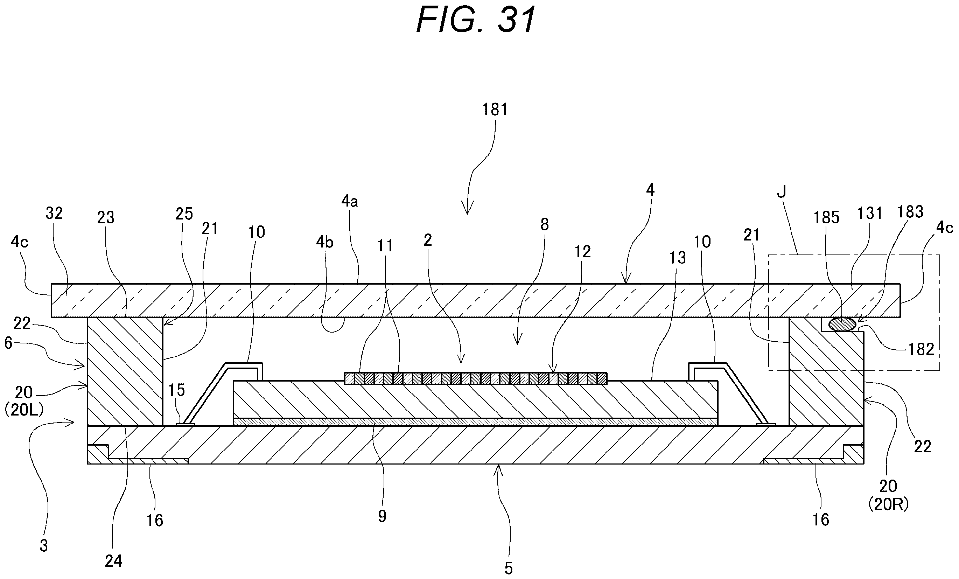

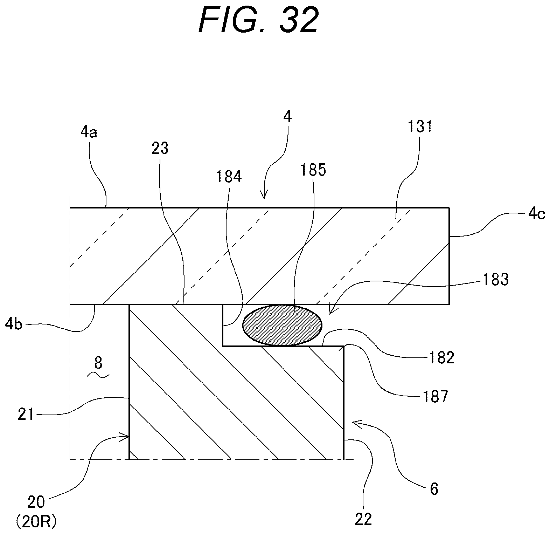

A configuration example of a solid-state imaging device 181 according to a fourth embodiment of the present technology will be described with reference to Figs. 31 and 32.

As illustrated in Figs. 31 and 32, in the solid-state imaging device 181 according to the present embodiment, the frame 6 has a fixed surface 182 formed at the upper end portion of the wall portion 20R as a surface to which the glass overhanging portion 131 is fixed. That is, the wall portion 20R has, on the outer side (right side) of the glass support surface 23, the fixed surface 182 to which the glass overhanging portion 31 is fixed and that forms a step lower in position than the glass support surface 23.

The fixed surface 182 is provided by forming a cutout-shaped step portion 183 at the upper end portion of the wall portion 20R. On the left and right outer sides (right side) of the upper end portion of the wall portion 20R, an upper end outer side surface 184 that is a surface on the opposite side of the upper end portion from the inner wall surface 21 and the fixed surface 182 that is a step surface parallel to the glass support surface 23 form the step portion 183. The step portion 183 is formed over the wall portion 20R in the Y direction (see Fig. 23).

In the solid-state imaging device 181, a rectangular plate-shaped glass plate having an upper surface 4a and a lower surface 4b is used as the cover glass 4. The fixed surface 182 of the frame 6 is located under the glass overhanging portion 131 and faces the lower surface 4b. The fixed surface 182 forms a right-angled corner portion 187 together with the outer wall surface 22 of the wall portion 20R. For example, the fixed surface 182 is formed to have a dimension of about half of the wall thickness of the wall portion 20R in the left-right direction.

As described above, in the configuration where the frame 6 has the step portion 183 forming the fixed surface 182, the glass overhanging portion 131 of the cover glass 4 is fixed to the fixed surface 182 with an adhesive. That is, the cover glass 4 is fixed to the frame 6 by the joint portion 185 including the adhesive with the lower surface 4b of the glass overhanging portion 131 as a surface bonded to the fixed surface 182.

The joint portion 185 is interposed between the lower surface 4b of the glass overhanging portion 31 and the fixed surface 182 of the frame 6. The adhesive forming the joint portion 185 includes, for example, a thermosetting resin or a photocurable resin such as an ultraviolet (UV) curable resin. Furthermore, as the adhesive forming the joint portion 185, for example, a polyamide-base or polyester-based hot melt adhesive can be used. Note that the hot melt adhesive is an adhesive containing neither water nor an organic solvent, is solid at room temperature, and becomes liquid when heated.

The adhesive is applied to the fixed surface 182 of the frame 6 at three points: a center portion and portions near both end portions in the Y direction, in a dot shape or a circular shape to form the joint portion 185. Note that the mode of applying the adhesive to the fixed surface 182, that is, the mode of forming the joint portion 185 is not particularly limited.

### <13. Use example of solid-state imaging device according to fourth embodiment>

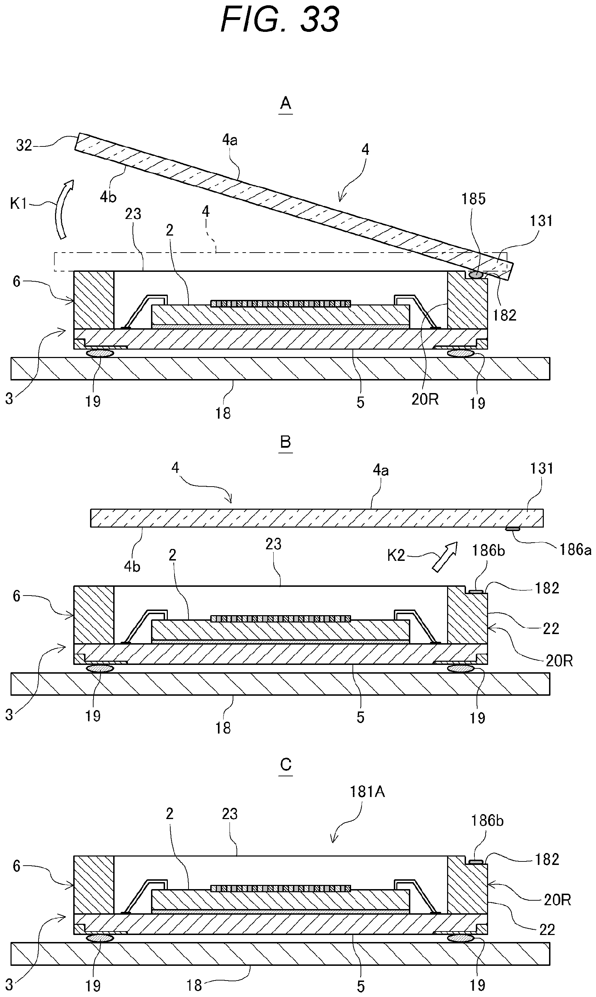

As a use example of the solid-state imaging device 181 according to the fourth embodiment of the present technology, how to remove the cover glass 4 will be described with reference to Fig. 33. In the solid-state imaging device 181, the cover glass 4 is removed in a manner similar to the first embodiment.

In order to remove the cover glass 4, from the state illustrated in Fig. 31, the opposite-side overhanging portion 32 serves as a holding portion, and the opposite-side overhanging portion 32 of the cover glass 4 is lifted to tilt the cover glass 4 as illustrated in Fig. 33A (see an arrow K1), so that the bonding portion of the glass overhanging portion 131 bonded to the main body portion of the frame 6 by the joint portion 185 is taken off.

When the opposite-side overhanging portion 32 of the cover glass 4 is lifted, the glass overhanging portion 131 receives a force in a direction away from the fixed surface 182. Then, when the cover glass 4 tilts to a certain angle, the bonding portion of the glass overhanging portion 131 by the joint portion 185 is taken off from the wall portion 20R.

As illustrated in Fig. 33B, when the glass overhanging portion 131 is separated from the wall portion 20R, the cover glass 4 is removed from the package main body portion 3 (see an arrow K2). The cover glass 4 thus removed may have an adhesive 186a that is a part of the joint portion 185 left on the lower surface 4b of the glass overhanging portion 131.

As a result, as illustrated in Fig. 33C, a solid-state imaging device 181A corresponding to the solid-state imaging device 181 from which the cover glass 4 has been removed is obtained. In the solid-state imaging device 181A, for example, on the fixed surface 182 of the wall portion 20R, an adhesive 186b that is a part of the joint portion 185 may exist as a fixation mark of the cover glass 4.

In the solid-state imaging device 181 according to the present embodiment as described above, since the cover glass 4 is bonded and fixed to the fixed surface 182 that is an outer step surface of the glass support surface 23 of the frame 6, the glass support surface 23 can be kept clean without leaving, with the cover glass 4 removed from the package main body portion 3, the adhesive on the glass support surface 23, and the cover glass 4 can be easily removed, in a manner similar to the solid-state imaging device 1 according to the first embodiment.

Furthermore, it is possible to recycle the cover glass 4 removed from the package main body portion 3 by cleaning the cover glass 4 to remove the adhesive 186a and the like. Furthermore, since a flat glass plate can be used as the cover glass 4, an existing cover glass can be used.

### <14. Modification of solid-state imaging device according to fourth embodiment>

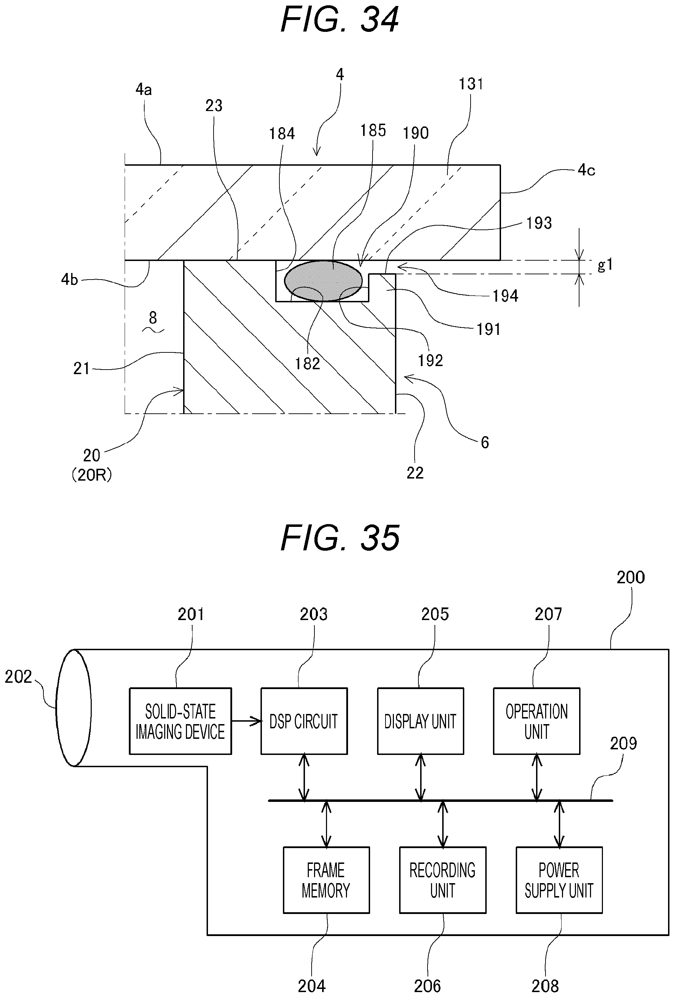

A modification of the solid-state imaging device 181 according to the fourth embodiment of the present technology will be described with reference to Fig. 34. As illustrated in Fig. 34, in this modification, the wall portion 20R of the frame 6 has a groove portion 190 formed with the fixed surface 182 as a bottom surface.

Providing a side wall portion 191 on the right side of the fixed surface 182 forms the groove portion 190. The groove portion 190 is a recessed portion having an approximately "U"-shaped cross-sectional shape with the upper side as an open side, and extends linearly along the Y direction (see Fig. 23).

The side wall portion 191 has an inner side surface 192 facing the upper end outer side surface 184 and an upper end surface 193 facing the lower surface 4b of the cover glass 4. The side wall portion 191 has a surface on the opposite side from the inner side surface 192 as an upper edge portion of the outer wall surface 22. The side wall portion 191 is provided so as to form a gap 194 between the lower surface 4b of the cover glass 4 and the upper end surface 193. That is, the side wall portion 191 is formed so as to make the upper end surface 193 lower in height position than the glass support surface 23 of the frame 6 by a predetermined dimension g1.

The side wall portion 191 is formed over the wall portion 20R in the Y direction. A space in the groove portion 190 serves as an adhesive application space, that is, a formation space of the joint portion 185. The cover glass 4 is fixed to the frame 6 by the joint portion 185 formed in the groove portion 190 with the lower surface 4b of the glass overhanging portion 131 as a surface bonded to the fixed surface 182.

As described above, the configuration where the groove portion 190 forming the fixed surface 182 is provided in the wall portion 20R of the frame 6 can prevent, in a case where the hot melt adhesive is used as the joint portion 185, the adhesive melted in the process of forming the joint portion 185 from protruding toward the outer wall surface 22 of the wall portion 20R.

### <15. Configuration example of electronic device>

An application example of the semiconductor device according to the above-described embodiments to an electronic device will be described with reference to Fig. 35.

The semiconductor device (solid-state imaging device) according to the present technology can be used as various types of devices that sense light such as visible light, infrared light, ultraviolet light, and X-rays, for example. The solid-state imaging device according to the present technology is applicable to all electronic devices using a solid-state imaging element as an image capturing unit (photoelectric converter), such as a camera device such as a digital still camera or a video camera, a mobile terminal device having an imaging function, a copying machine using a solid-state imaging element as an image reading unit, an in-vehicle sensor that captures images of the front, rear, surroundings, inside, and the like of an automobile, and a ranging sensor that measures a distance between vehicles and the like. Furthermore, the solid-state imaging device may be formed as one chip, or may be in the form of a module having an imaging function in which an imaging unit and a signal processing unit or an optical system are packaged together.

As illustrated in Fig. 35, a camera device 200 as an electronic device includes an optical unit 202, a solid-state imaging device 201, a digital signal processor (DSP) circuit 203 which is a camera signal processing circuit, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are appropriately connected via a connection line 209 such as a bus line. The solid-state imaging device 201 is any one of the solid-state imaging devices according to the above-described embodiments. Furthermore, the solid-state imaging device 201 may be a solid-state imaging device with the cover glass 4 removed, such as the solid-state imaging device 1A (see Fig. 9C), for example.

The optical unit 202 includes a plurality of lenses, and captures incident light (image light) from a subject to form an image on an imaging surface of the solid-state imaging device 201. The solid-state imaging device 201 converts the light amount of the incident light imaged on the imaging surface by the optical unit 202 into an electrical signal for each pixel and outputs the electrical signal as a pixel signal.

The display unit 205 includes, for example, a panel type display device such as a liquid crystal panel or an organic electro luminescence (EL) panel, and displays a moving image or a still image captured by the solid-state imaging device 201. The recording unit 206 records the moving image or the still image captured by the solid-state imaging device 201 on a recording medium such as a hard disk or a semiconductor memory.

The operation unit 207 issues operation commands for various functions of the camera device 200 under operation by the user. The power supply unit 208 appropriately supplies various power sources serving as operation power sources of the DSP circuit 203, the frame memory 204, the display unit 205, the recording unit 206, and the operation unit 207 to supply targets.

The camera device 200 as described above makes, for the solid-state imaging device 201, the cover glass 4 easy to remove without leaving, with the cover glass 4 removed from the package main body portion 3, the adhesive for fixing the cover glass 4 on the glass support surface 23 of the package main body portion 3.

The description of the above-described embodiments is an example of the present technology, and the present technology is not limited to the above-described embodiments. For this reason, it is a matter of course that various modifications can be made according to the design and the like without departing from the technical idea according to the present disclosure even in a case other than the above-described embodiments. Furthermore, the effects described in the present disclosure are merely examples and are not limited, and other effects may be provided. Furthermore, the configurations of the above-described embodiments and the configuration of each modification can be appropriately combined.

In the above-described embodiments, the semiconductor element is the image sensor 2 that is a light receiving element, but the semiconductor element according to the present technology is not limited to an image sensor. The semiconductor element according to the present technology may be, for example, a light emitting element such as a vertical cavity surface emitting laser (VCSEL), a laser diode, or a light emitting diode (LED). Furthermore, the imaging device as a semiconductor device may have a configuration where a plurality of semiconductor elements is provided in one chip or a configuration where a plurality of semiconductor elements is provided as a plurality of chips.

Furthermore, in the above-described embodiments, the transparent cover glass 4 has been given as an example of the cover member according to the present technology, but the cover member according to the present technology is not limited to a transparent member, and may be a translucent or opaque cover body.

Note that the present technology may have the following configurations.
(1) A semiconductor device including:
   a semiconductor element;
   a package main body portion including a substrate portion on which the semiconductor element is installed and a frame portion that is provided on the substrate portion so as to surround the semiconductor element and has an opening portion formed on an upper side; and
   a cover member that closes the opening portion with the cover member supported by a support surface forming an opening end surface of the opening portion of the package main body portion, in which
   the cover member includes an overhanging portion that sticks out over an outline of the support surface in plan view and is provided with the overhanging portion fixed to the frame portion.
(2) The semiconductor device according to the above (1), in which
   the frame portion includes a wall portion provided on four sides, the wall portion forming the support surface in a rectangular frame shape in plan view,
   the overhanging portion is a portion extending along at least one side of the outline of the support surface in plan view, and
   the package main body portion includes a cover fixing portion that is provided on an outer side of the wall portion and to which the overhanging portion is fixed.
(3) The semiconductor device according to the above (2), in which
   the cover fixing portion includes a plate-shaped portion that is provided at an upper end portion of the wall portion and has an upper plate surface as a fixed surface to which the overhanging portion is fixed.
(4) The semiconductor device according to the above (3), in which the cover fixing portion includes a fragile portion provided adjacent to the wall portion, the fragile portion having reduced stiffness in a direction in which the fragile portion breaks downward.
(5) The semiconductor device according to the above (2), in which the cover fixing portion includes:
   a main body portion provided at a position spaced apart from the wall portion, the main body portion having an upper surface as a fixed surface to which the overhanging portion is fixed; and
   a connecting portion that connects the main body portion and the wall portion and is lower in stiffness than the main body portion.
(6) The semiconductor device according to the above (5), in which
   the connecting portion includes a plurality of rib portions provided at predetermined intervals in a direction of a side of the support surface, and
   the fixed surface has a joint portion provided in an area where none of the rib portions is formed in the direction of the side, the joint portion including an adhesive with which the overhanging portion is fixed.
(7) The semiconductor device according to any one of the above (3) to (6), in which
   the overhanging portion is fixed to the fixed surface by a joint portion including an adhesive, and
   the cover fixing portion is provided so as to make the fixed surface lower in position than the support surface by a thickness of the joint portion.
(8) The semiconductor device according to the above (1), in which
   the frame portion includes a wall portion provided on four sides, the wall portion forming the support surface in a rectangular frame shape in plan view, and
   the overhanging portion includes a fixing surface forming portion, the fixing surface forming portion extending along at least one side of the outline of the support surface in plan view, and having a fixing surface formed facing an outer side surface of the wall portion.
(9) The semiconductor device according to the above (8), in which the fixing surface forming portion has a lower end surface, the lower end surface being lower in position than a supported surface of the cover member supported by the support surface and forming a corner portion with the fixed surface, the corner portion having a chamfered shape.
(10) The semiconductor device according to the above (1), in which
   the frame portion includes a wall portion provided on four sides, the wall portion forming the support surface in a rectangular frame shape in plan view, and
   the wall portion has, on outer side of the support surface, a fixed surface to which the overhanging portion is fixed, the fixed surface forming a step lower than the support surface.
(11) The semiconductor device according to the above (10), in which
   the wall portion forms a groove portion having the fixed surface as a bottom surface.
(12) The semiconductor device according to any one of the above (2), (8), and (10), in which
   the cover member has an opposite-side overhanging portion provided on an opposite side from the overhanging portion, the opposite-side overhanging portion sticking out over the outline of the support surface in plan view.
(13) An electronic device including a semiconductor device, the semiconductor device including:
   a semiconductor element;
   a package main body portion including a substrate portion on which the semiconductor element is installed and a frame portion that is provided on the substrate portion so as to surround the semiconductor element and has an opening portion formed on an upper side; and
   a cover member that closes the opening portion with the cover member supported by a support surface forming an opening end surface of the opening portion of the package main body portion, in which
   the cover member includes an overhanging portion that sticks out over an outline of the support surface in plan view and is provided with the overhanging portion fixed to the frame portion.
(14) An electronic device including a semiconductor device, the semiconductor device including:
   a semiconductor element; and
   a package main body portion including a substrate portion on which the semiconductor element is installed and a frame portion that is provided on the substrate portion so as to surround the semiconductor element and has an opening portion formed on an upper side, in which
   the package main body portion has a fixation mark of a cover member that closes the opening portion of the package main body portion with the cover member supported by a support surface forming an opening end surface of the opening portion.

### REFERENCE SIGNS LIST

- 1: Solid-state imaging device (semiconductor device)
- 1A: Solid-state imaging device (semiconductor device)
- 2: Image sensor (semiconductor element)
- 3: Package main body portion
- 4: Cover glass (cover member)
- 4b: Lower surface (supported surface)
- 5: Substrate (substrate portion)
- 6: Frame (frame portion)
- 20: Wall portion
- 22: Outer wall surface (outer side surface)
- 23: Glass support surface (support surface)
- 25: Opening portion
- 29: Mark (fixation mark)
- 31: Glass overhanging portion (overhanging portion)
- 32: Opposite-side overhanging portion
- 40: Flange portion (cover fixing portion)
- 41: Fixed surface
- 45: Fragile portion
- 48: Joint portion
- 71: Solid-state imaging device (semiconductor device)
- 71A: Solid-state imaging device (semiconductor device)
- 80: Flange portion (cover fixing portion)
- 81: Flange main body portion (main body portion)
- 82: Connecting portion
- 83: Fixed surface
- 89: Mark (fixation mark)
- 92: Rib portion
- 95: Fragile portion
- 121: Solid-state imaging device (semiconductor device)
- 121A: Solid-state imaging device (semiconductor device)
- 131: Glass overhanging portion (overhanging portion)
- 141: Fixing surface forming portion
- 142: Fixing surface
- 143: Step surface
- 147: Inner corner portion (corner portion)
- 149: Inclined surface
- 149b: Adhesive (fixation mark)
- 160: Cavity substrate (package main body portion)
- 161: Substrate portion
- 162: Frame portion
- 181: Solid-state imaging device (semiconductor device)
- 181A: Solid-state imaging device (semiconductor device)
- 182: Fixed surface
- 186b: Adhesive (fixation mark)
- 190: Groove portion
- 200: Camera device (electronic device)
- 201: Solid-state imaging device (semiconductor device)

## Claims

1. A semiconductor device comprising:
a semiconductor element;
a package main body portion including a substrate portion on which the semiconductor element is installed and a frame portion that is provided on the substrate portion so as to surround the semiconductor element and has an opening portion formed on an upper side; and
a cover member that closes the opening portion with the cover member supported by a support surface forming an opening end surface of the opening portion of the package main body portion, wherein
the cover member includes an overhanging portion that sticks out over an outline of the support surface in plan view and is provided with the overhanging portion fixed to the frame portion.

2. The semiconductor device according to claim 1, wherein
the frame portion includes a wall portion provided on four sides, the wall portion forming the support surface in a rectangular frame shape in plan view,
the overhanging portion is a portion extending along at least one side of the outline of the support surface in plan view, and
the package main body portion includes a cover fixing portion that is provided on an outer side of the wall portion and to which the overhanging portion is fixed.

3. The semiconductor device according to claim 2, wherein
the cover fixing portion includes a plate-shaped portion that is provided at an upper end portion of the wall portion and has an upper plate surface as a fixed surface to which the overhanging portion is fixed.

4. The semiconductor device according to claim 3, wherein
the cover fixing portion includes a fragile portion provided adjacent to the wall portion, the fragile portion having reduced stiffness in a direction in which the fragile portion breaks downward.

5. The semiconductor device according to claim 2, wherein
the cover fixing portion includes:
a main body portion provided at a position spaced apart from the wall portion, the main body portion having an upper surface as a fixed surface to which the overhanging portion is fixed; and
a connecting portion that connects the main body portion and the wall portion and is lower in stiffness than the main body portion.

6. The semiconductor device according to claim 5, wherein
the connecting portion includes a plurality of rib portions provided at predetermined intervals in a direction of a side of the support surface, and
the fixed surface has a joint portion provided in an area where none of the rib portions is formed in the direction of the side, the joint portion including an adhesive with which the overhanging portion is fixed.

7. The semiconductor device according to claim 3, wherein
the overhanging portion is fixed to the fixed surface by a joint portion including an adhesive, and
the cover fixing portion is provided so as to make the fixed surface lower in position than the support surface by a thickness of the joint portion.

8. The semiconductor device according to claim 1, wherein
the frame portion includes a wall portion provided on four sides, the wall portion forming the support surface in a rectangular frame shape in plan view, and
the overhanging portion includes a fixing surface forming portion, the fixing surface forming portion extending along at least one side of the outline of the support surface in plan view, and having a fixing surface formed facing an outer side surface of the wall portion.

9. The semiconductor device according to claim 8, wherein
the fixing surface forming portion has a lower end surface, the lower end surface being lower in position than a supported surface of the cover member supported by the support surface and forming a corner portion with the fixed surface, the corner portion having a chamfered shape.

10. The semiconductor device according to claim 1, wherein
the frame portion includes a wall portion provided on four sides, the wall portion forming the support surface in a rectangular frame shape in plan view, and
the wall portion has, on outer side of the support surface, a fixed surface to which the overhanging portion is fixed, the fixed surface forming a step lower than the support surface.

11. The semiconductor device according to claim 10, wherein
the wall portion forms a groove portion having the fixed surface as a bottom surface.

12. The semiconductor device according to claim 2, wherein
the cover member has an opposite-side overhanging portion provided on an opposite side from the overhanging portion, the opposite-side overhanging portion sticking out over the outline of the support surface in plan view.

13. An electronic device comprising a semiconductor device, the semiconductor device including:
a semiconductor element;
a package main body portion including a substrate portion on which the semiconductor element is installed and a frame portion that is provided on the substrate portion so as to surround the semiconductor element and has an opening portion formed on an upper side; and
a cover member that closes the opening portion with the cover member supported by a support surface forming an opening end surface of the opening portion of the package main body portion, wherein
the cover member includes an overhanging portion that sticks out over an outline of the support surface in plan view and is provided with the overhanging portion fixed to the frame portion.

14. An electronic device comprising a semiconductor device, the semiconductor device including:
a semiconductor element; and
a package main body portion including a substrate portion on which the semiconductor element is installed and a frame portion that is provided on the substrate portion so as to surround the semiconductor element and has an opening portion formed on an upper side, wherein
the package main body portion has a fixation mark of a cover member that closes the opening portion of the package main body portion with the cover member supported by a support surface forming an opening end surface of the opening portion.
